# EUROPEAN PATENT SPECIFICATION

(11) **EP 4 109 544 B1**
(45) Date of publication and mention of the grant of the patent: **29.04.2026**
(21) Application number: 22160673.4
(22) Date of filing: 08.03.2022
(51) Int. Cl.: H10K 59/38, H10K 59/80

(54) **DISPLAY APPARATUS**
ANZEIGEVORRICHTUNG
APPAREIL D'AFFICHAGE

(30) Priority: 22.06.2021 KR 20210081042
(43) Date of publication of application: 28.12.2022
(73) Proprietor: Samsung Display Co., Ltd., Yongin-si, Gyeonggi-do 17113 (KR)
(72) Inventor: KIM, Seulong, 17113 Yongin-si (KR); PARK, Eungyoung, 17113 Yongin-si (KR); SONG, Jiyoung, 17113 Yongin-si (KR); SONG, Hajin, 17113 Yongin-si (KR); HWANG, Jaehoon, 17113 Yongin-si (KR)
(74) Representative: Marks & Clerk LLP

(56) References cited:
- EP-A1- 3 282 310
- EP-A1- 3 553 821
- CN-A- 110 729 336
- US-A1- 2019 391 444

## Description

### BACKGROUND

### 1. Field

One or more aspects of embodiments of the present disclosure relate to a display apparatus.

### 2. Description of the Related Art

Light-emitting display apparatuses have self-emission characteristics, and, unlike liquid crystal display apparatuses, do not need a separate light source, and thus a thickness and a weight may be reduced for the apparatus. Also, light-emitting display apparatuses have high-quality characteristics such as low consumption power, high luminance, and high response speed. A polarizing plate or a color filter may be generally used in order to read an image implemented through light-emitting display apparatuses, not only indoors but also outdoors (outside).

US 2019/391444 A1 relates to a display device.

EP 3553821 A1 relates to a display device.

### SUMMARY

A display apparatus with improved blue luminance, white luminescence efficiency, and color matching rate is provided.

Additional aspects will be set forth in part in the detailed description, which follows and, in part, will be apparent from the detailed description, or may be learned by practice of the presented embodiments.

A display apparatus according to an aspect includes:
a substrate,
a light-emitting device layer arranged on the substrate, wherein the light-emitting device layer includes a first area, a second area, and a third area, and wherein the light-emitting device layer further includes at least one light-emitting device emitting a first light, and
a color conversion layer arranged on the light-emitting device layer, wherein the color conversion layer includes a first color conversion area, a second color conversion area, and a third color conversion area,
wherein the first color conversion area is arranged to correspond to the first area of the light-emitting device layer, and emits a first color light,
the second color conversion area is arranged to correspond to the second area of the light-emitting device layer, and emits a second color light,
the third color conversion area is arranged to correspond to the third area of the light-emitting device layer, and emits a third color light,
a maximum emission wavelength of the first color light, a maximum emission wavelength of the second color light, and a maximum emission wavelength of the third color light are greater than a maximum emission wavelength of the first light,
a color of the third color light is identical to that of the first light, and
the maximum emission wavelength of the third color light is greater than the maximum emission wavelength of the first light, wherein the first color conversion area comprises a first emitter, the second color conversion area comprises a second emitter, and the third color conversion area comprises a third emitter, the first emitter and the second emitter each independently comprise a phosphorescent dopant, a fluorescent dopant, a delayed fluorescence material, a quantum dot, or a combination, thereof, the third emitter comprises a phosphorescent dopant, a fluorescent dopant, a delayed fluorescence material, or a combination thereof.

In one or more embodiments, the maximum emission wavelength of the third color light may be 5 nanometers (nm) or more greater than the maximum emission wavelength of the first light.

In one or more embodiments, the first emitter, the second emitter, and the third emitter may be different from one another.

In one or more embodiments, the first emitter may be arranged in a first path of the first light emitted from a portion corresponding to the first area of the light-emitting device layer, the second emitter may be arranged in a second path of the first light emitted from a portion corresponding to the second area of the light-emitting device layer, and the third emitter may be arranged in a third path of the first light emitted from a portion corresponding to the third area of the light-emitting device layer.

In one or more embodiments, the third color conversion area may include the third emitter in an amount of 1 weight percent (wt%) to 50 wt% based on a total weight of the third color conversion area.

In one or more embodiments, the maximum emission wavelength of the third emitter may be 425 nm to 465 nm.

In one or more embodiments, at least one of the first color conversion area, the second color conversion area, and the third color conversion area may further include a scatterer.

In one or more embodiments, the scatterer may include BiFeO₃, Fe₂O₃, WO₃, TiO₂, SiC, BaTiO₃, ZnO, ZrO₂, ZrO, Ta₂O₅, MoO₃, TeO₂, Nb₂O₅, Fe₃O₄, V₂O₅, Cu₂O, BP, Al₂O₃, In₂O₃, SnO₂, Sb₂O₃, ITO, or a combination thereof.

In one or more embodiments, each light-emitting device of the at least one light-emitting device may include a first electrode, a second electrode facing the first electrode, and an interlayer arranged between the first electrode and the second electrode, wherein the interlayer includes at least one emission layer.

In one or more embodiments, each emission layer of the at least one emission layer may independently include a phosphorescent dopant, a fluorescent dopant, a delayed fluorescence material, a quantum dot, or a combination thereof. The phosphorescent dopant, the fluorescent dopant, the delayed fluorescence material, and the quantum dot are respectively as those described herein.

In one or more embodiments, the at least one light-emitting device is a tandem light-emitting device including at least two emission zones sequentially stacked between the first electrode and the second electrode, and a charge generation layer arranged between the at least two emission zones.

In one or more embodiments, the at least two emission zones included in the tandem light-emitting device may emit light having maximum emission wavelengths that are identical to or different from each other.

In one or more embodiments, the maximum emission wavelength of the first light may be 420 nm to 460 nm.

In one or more embodiments, the display apparatus may include at least one color filter arranged on the color conversion layer to correspond to at least one of the first color conversion area, the second color conversion area, the third color conversion area, or a combination thereof.

At least some of the above and other features of the invention are set out in the claims.

### BRIEF DESCRIPTION OF THE DRAWINGS

The above and other aspects, features, and advantages of embodiments will be more apparent from the following description taken in conjunction with the accompanying drawings, in which:
FIG. 1 is a schematic view of a display apparatus according to one or more embodiments;
FIG. 2 is a schematic view of a color conversion layer portion in the display apparatus of FIG. 1;
FIG. 3 illustrates an emission/absorption spectrum of a light-emitting device layer and a blue color conversion area of a display apparatus according to one or more embodiments;
FIG. 4 is a schematic cross-sectional view of a light-emitting device according to one or more embodiments;
FIG. 5 is a schematic cross-sectional view of a light-emitting device according to another embodiment;
FIG. 6 is a cross-sectional view of a light-emitting apparatus according to one or more embodiments; and
FIG. 7 is a cross-sectional view of a light-emitting apparatus according to another embodiment.

### DETAILED DESCRIPTION

Reference will now be made in detail to embodiments, examples of which are illustrated in the accompanying drawings, wherein like reference numerals refer to like elements throughout the specification. In this regard, the embodiments may have different forms and should not be construed as being limited to the detailed descriptions set forth herein. Accordingly, the embodiments are merely described in detail below, by referring to the figures, to explain one or more aspects of the detailed description.

The terminology used herein is for the purpose of describing one or more embodiments only and is not intended to be limiting. As used herein, the singular forms "a," "an," and "the" are intended to include the plural forms as well, unless the context clearly indicates otherwise. The term "or" means "and/or." As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

An expression used in the singular encompasses the expression of the plural, unless it has a clearly different meaning in the context.

It will be further understood that the terms "comprises" and/or "comprising" or "includes" and/or "including" when used herein specify the presence of stated features, regions, integers, steps, operations, elements, components, and/or groups thereof, but do not preclude the presence or addition of one or more other features, regions, integers, steps, operations, elements, components, and/or groups thereof.

It will be understood that when a layer, area, or component is referred to as being "on" or "onto" another layer, area, or component, it may be directly or indirectly formed on the other layer, area, or component. That is, for example, intervening layers, areas, or components may be present. In contrast, when an element is referred to as being "directly on" another element, there are no intervening elements present.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Sizes of elements in the drawings may be exaggerated for convenience of explanation. In other words, because sizes and thicknesses of components in the drawings are arbitrarily illustrated for convenience of explanation, the following embodiments are not limited thereto.

When a certain embodiment is implemented differently, a specific process order may be performed differently from the described order. For example, two processes described in succession may be performed substantially simultaneously, or may be performed in an order opposite to the described order.

It will be understood that when a layer, area, or component is referred to as being "connected to" another layer, area, or component, the layer, area, or component may be directly connected to the another layer, area, or component, or indirectly connected to the another layer, area, or component if an intervening layer, area, or component is present. For example, it will be understood that when a layer, area, or component is referred to as being "electrically connected to" another layer, area, or component, the layer, area, or component may be directly electrically connected to the another layer, area, or component, or indirectly electrically connected to the another layer, area, or component if an intervening layer, area, or component is present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

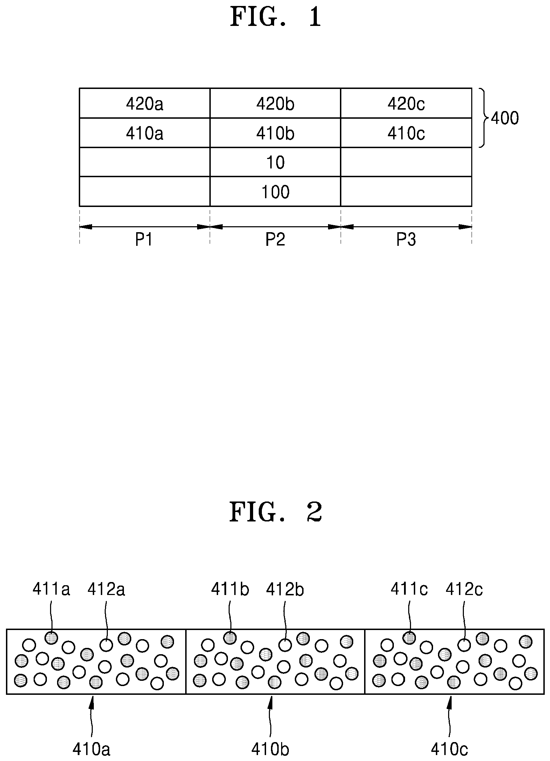

FIG. 1 is a schematic plan view of a display apparatus according to one or more embodiments.

Referring to FIG. 1, the display apparatus includes: a substrate 100; a light-emitting device layer arranged on the substrate 100, including a first area P1, a second area P2, and a third area P3, and including at least one light-emitting device 10 emitting a first light; and a color conversion layer arranged on the light-emitting device layer and including a first color conversion area 410a, a second color conversion area 410b, and a third color conversion area 410c, wherein the first color conversion area 410a is arranged to correspond to the first area P1 and emits a first color light, the second color conversion area 410b is arranged to correspond to the second area P2 and emits a second color light, the third color conversion area 410c is arranged to correspond to the third area P3 and emits a third color light, a maximum emission wavelength of the first color light, the second color light, and the third color light are each greater than a maximum emission wavelength of the first light, a color of the third color light is identical to a color of the first light, and the maximum emission wavelength of the third color light is greater than the maximum emission wavelength of the first light.

In the present specification, colors and wavelengths of the first light, the first color light, the second color light, and the third color light were obtained by measuring the emission wavelength of the emission layer formed as a single film by a Quantaurus-QY Absolute PL quantum yield spectrometer apparatus.

For example, the display apparatus may include at least one of color filters 420a, 420b, and 420c (also respectively referred to as a first color filter 420a, a second color filter 420b, and a third color filter 420c) arranged on the color conversion layer to correspond to at least one of the first to third color conversion areas 410a, 410b, and 410c, respectively.

In one or more embodiments, the first color filter 420a may be arranged on the first color conversion area 410a, the second color filter 420b may be arranged on the second color conversion area 410b, and the third color filter 420c may be arranged on the third color conversion area 410c. In one or more embodiments, the third color filter 420c may be omitted. The color filters 420a, 420b, and 420c are respectively as those described herein.

A functional area 400 described below may include the first to third color conversion areas 410a, 410b, and 410c, respectively, and the corresponding color filters 420a, 420b, and 420c, respectively.

In one or more embodiments, the maximum emission wavelength of the first light may be 420 nm to 460 nm.

In one or more embodiments, the first color light may be red light or green light, the second color light may be green light or red light, and the first light and the third color light may be blue light.

As used herein, and unless otherwise noted herein, "red light" refers to light having a maximum emission wavelength of about 610 nm to about 640 nm. As used herein, "green light" refers to light having a maximum emission wavelength of about 510 nm to about 550 nm. As used herein, "blue light" refers to light having a maximum emission wavelength of about 420 nm to about 460 nm.

In the display apparatus, both luminescence efficiency and color matching rate are important characteristics, and both characteristics may be improved.

In this regard, in the display apparatus, as a short wavelength component of emission components of the light-emitting device increases, red and green luminescence efficiency may be improved, but blue light is shortened in wavelength by the increase in the short wavelength component, such that luminance of blue emission decreases, resulting in a decrease in white luminescence efficiency. Also, even when the white luminescence efficiency increases, overall color matching rate decreases.

Therefore, in the disclosure, the maximum emission wavelength of the third color light of the color conversion layer has a longer wavelength than that of the first light emitted from the light-emitting device layer. Accordingly, luminance of the display apparatus is improved by converting an emission spectrum to a longer wavelength.

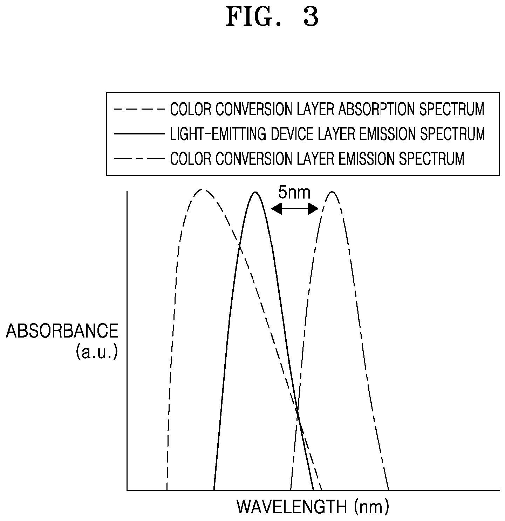

Referring to FIG. 3, the maximum emission wavelength of the third color light may be 5 nm or more greater than the maximum emission wavelength of the first light. In one or more embodiments, the maximum emission wavelength of the third color light may be 10 nm or more greater than the maximum emission wavelength of the first light.

Referring to FIG. 2, the first color conversion area 410a includes a first emitter 411a, the second color conversion area 410b includes a second emitter 411b, and the third color conversion area 410c includes a third emitter 411c.

The first emitter 411a absorbs the first light, coverts the first light to the first color light, and emits the first color light, the second emitter 411b absorbs the first light, converts the first light to the second color light, and emits the second color light, and the third emitter 411c absorbs the first light, converts the first light to the third color light, and emits the third color light. It is to be understood that in this case, the first light includes a first portion of the first light, a second portion of the first light, and a third portion of the first light that, wherein the first portion of the first light is absorbed by the first emitter 411a, the second portion of the first light is absorbed by the second emitter 411b, and the third portion of the first light is absorbed by the third emitter 411c.

In one or more embodiments, the first emitter 411a, the second emitter 411b, and the third emitter 411c may each absorb the first light (i.e., each of the first, second, and third emitters absorbs a portion of the first light) emitted from the light-emitting device layer and emit light, and the first emitter 411a, the second emitter 411b, and the third emitter 411c absorb light diffusedly reflected from the color conversion layer, go through a re-emission process, and convert an emission spectrum to a long wavelength, thereby improving luminance.

For example, the first emitter 411a, the second emitter 411b, and the third emitter 411c may each emit light having a maximum emission wavelength that is 5 nm or more greater than the maximum emission wavelength of the first light. In other words, the light emitted from the first emitter, the second emitter, and/or the third emitter may each have a maximum emission wavelength that is at least 5 nm greater than the maximum emission wavelength of the first light.

The first emitter 411a is arranged in a first path of the first light emitted from a portion corresponding to the first area P1 in the light-emitting device layer, the second emitter 411b is arranged in a second path of the first light emitted from a portion corresponding to the second area P2 in the light-emitting device layer, and the third emitter 411c is arranged in a third path of the first light emitted from a portion corresponding to the third area P3 in the light-emitting device layer.

The first emitter 411a may be included in an amount of 1 weight percent (wt%) to 50 wt%, or 5 wt% to 45 wt%, or 10 wt% to 40 wt%, based on a total weight of the first color conversion area 410a.

The second emitter 411b may be included in an amount of 1 wt% to 50 wt%, or 5 wt% to 45 wt%, or 10 wt% to 40 wt%, based on a total weight of the second color conversion area 410b.

The third emitter 411c may be included in an amount of 1 wt% to 50 wt%, or 5 wt% to 45 wt%, or 10 wt% to 40 wt%, based on a total weight of the third color conversion area 410c.

The first emitter 411a, the second emitter 411b, the third emitter 411c may be different from each other. In other words, in some embodiments, the first emitter 411a, the second emitter 411b and the third emitter 411c do not comprise the same emitter compound(s).

A maximum emission peak of the first emitter 411a may be 620 nm to 660 nm, or 625 nm to 655 nm, or 630 nm to 650 nm.

A maximum emission peak of the second emitter 411b may be 515 nm to 555 nm, or 520 nm to 555 nm, or 525 to 550 nm.

A maximum emission peak of the third emitter 411c may be 425 nm to 465 nm, or 430 nm to 460 nm, or 435 nm to 455 nm.

The first emitter 411a, the second emitter 411b, and the third emitter 411c will be described in further detail with reference to the detailed descriptions of a phosphorescent dopant, a fluorescent dopant, a delayed fluorescence material, and a quantum dot that may be included in an emission layer.

At least one of the first color conversion area, the second color conversion layer, and/or the third color conversion area 410a, 410b, and 410c, respectively, may further include corresponding scatterers 412a, 412b, and 412c, respectively.

The scatterers 412a, 412b, and 412c may include a plurality of inorganic particles having different particle diameters.

In one or more embodiments, the scatterers 412a, 412b, and 412c may include at least one of BiFeO₃, Fe₂O₃, WO₃, TiO₂, SiC, BaTiO₃, ZnO, ZrO₂, ZrO, Ta₂O₅, MoO₃, TeO₂, Nb₂O₅, Fe₃O₄, V₂O₅, Cu₂O, BP, Al₂O₃, In₂O₃, SnO₂, Sb₂O₃, indium tin oxide (ITO), or a combination thereof.

In one or more embodiments, the inorganic particles may have an average particle diameter (D50) of about 20 nm to about 2 micrometers (µm), or about 100 nm to about 1 µm, or about 100 to about 300 nm.

In one or more embodiments, the inorganic particles may have a refractive index of greater than 1.5 (at 589 nm). For example, the inorganic particles may have a refractive index of 1.6 or greater (at 589 nm).

Without wishing to be bound to theory, because the scatterers 412a, 412b, and 412c include the inorganic particles having various particle diameters as described above, the refractive index may be increased, such that a difference in refractive index with neighboring members becomes large, and thus, a probability of total reflection of blue light increases, resulting in an increase in blue light absorption rate and improvement in light conversion efficiency.

In one or more embodiments, the scatterers 412a, 412b, and 412c may have a refractive index of greater than 1.5, and may include an inorganic particle having an average particle diameter (D50) of about 100 nm to about 300 nm.

In one or more embodiments, the scatterers 412a, 412b, and 412c may include TiO₂.

In one or more embodiments, amounts of the scatterers 412a, 412b, and 412c may be 1 part by weight to 20 parts by weight, for example, 1 part by weight to 10 parts by weight, or 2 parts by weight to 8 parts by weight, based on a total amount of 100 parts by weight of the first to third color conversion areas 410a, 410b, and 410c, respectively.

In one or more embodiments, the color conversion layer may be formed from an ink composition. The ink composition may include at least one of the first to third emitters 411a, 411b, or 411c, respectively, at least one of the first to third scatterers 412a, 412b, and 412c, respectively, and a solvent.

In one or more embodiments, the solvent may include an alcohol-containing solvent, an ether-containing solvent, an aliphatic hydrocarbon solvent, an aromatic hydrocarbon solvent, or a combination thereof.

In one or more embodiments, the solvent may include methanol, ethanol, propanol, butanol, pentanol, hexanol, heptanol, octanol, nonanol, decanol, n-octane, n-nonane, n-decane, n-undecane, n-dodecane, n-tridecane, n-tetradecane, n-pentadecane, n-hexadecane, 2-methylheptane, 3-methylheptane, 4-methylheptane, 2,2-dimethylhexane, 2,3-dimethylhexane, 2,4-dimethylhexane, 2,5-dimethylhexane, 3,3-dimethylhexane, 3-ethylhexane, 2,2,4-trimethylpentane, 2-methyloctane, 2-methylnonane, 2-methyldecane, 2-methylundecane, 2-methyldodecane, 2-methyltridecane, methylcyclohexane, ethylcyclohexane, 1,1-dimethylcyclohexane, 1,2-dimethylcyclohexane, cycloheptane, methylcycloheptane, bicyclohexyl, decalin, toluene, xylene, ethylbenzene, diethylbenzene, mesitylene, propylbenzene, cyclohexylbenzene, dimethoxybenzene, anisole, ethoxytoluene, phenoxytoluene, isopropylbiphenyl, dimethylanisole, propylanisole, 1-ethylnaphthalene, 2-ethylnaphthalene, 2-ethylbiphenyl, octylbenzene, 1,3-dipropoxybenzene, 4-methoxybenzaldehyde-dimethyl-acetal, 4,4'-difluorodiphenylmethane, diphenylether, 1,2-dimethoxy-4-(1-propenyl)benzene, 2-phenoxytoluene, diphenylmethane, 2-phenylpyridine, dimethyl benzyl ether, 3-phenoxytoluene, 3-phenylpyridine, 2-phenylanisole, 2-phenoxytetrahydrofuran, 1-propyl-4-phenyl benzene, 2-phenoxy-1,4-dimethyl benzene, ethyl-2-naphtyl-ether, dodecylbenzene, 2,2,5-tri-methyl diphenyl ether, dibenzyl-ether, 2,3,5-tri-methyl diphenyl ether, N-methyldiphenylamine, 4-isopropylbiphenyl, α,α-dichlorodiphenylmethane, 4-(3-phenylpropyl)pyridine, methyl benzoate, ethyl benzoate, n-propyl benzoate, isopropyl benzoate, t-butyl benzoate, benzyl-benzoate, 1,1-bis(3,4-dimethylphenyl)ethane, diethylene glycol butylmethyl ether (DEGBME), diethylene glycol monomethyl ether (DEGME), diethylene glycol ethylmethyl ether (DEGEME), diethylene glycol dibutyl ether (DEGDBE), propylene glycol methyl ether acetate (PGMEA), triethylene glycol monomethyl ether (TGME), diethylene glycol monobutyl ether (DGBE), cyclohexylbenzene, propylene glycol methyl ether acetate, triethylene glycol monomethyl ether, diethylene glycol monobutyl ether, or a combination thereof, but embodiments are not limited thereto.

In one or more embodiments, the display apparatus may have a BT2020 color matching rate of 89 % or more. BT2020 refers to a color standard representing UHD (4K), and may express a wider color gamut than CIE1931, which is an existing color standard. A BT20 color matching rate refers to a ratio of a variation area formed by variation coordinates that are actually implemented color coordinates in a reference area formed by reference coordinates of the color standard representing UHD (4K).

Although a display surface of the display apparatus is not separately shown in FIG. 1, the display apparatus may include a flat display surface, a three-dimensional display surface, or a curved display surface.

In one or more embodiments, when the display apparatus includes a flat display surface, the display apparatus may include a plurality of display areas indicating different directions, and for example, may include a polyprism-type (i.e., a polygon-like shape that is elongated in the longitudinal direction and has an aspect ratio of greater than 1) display surface. In one or more embodiments, when the display apparatus includes a curved display surface, the display apparatus may be implemented in various forms such as a flexible, foldable, or rollable display apparatus.

Although a shape of a display area of the display apparatus is not separately shown in FIG. 1, the display area may be a quadrangle with angled corners, a circle, an ellipse, a polygon such as a triangle or a pentagon, or a polygon with rounded corners.

As the substrate 100, a glass substrate or a plastic-glass may be used. In one or more embodiments, the substrate 100 may be a flexible substrate, and may include plastics with excellent heat resistance and durability, such as polyimide, polyethylene terephthalate (PET), polycarbonate, polyethylene naphthalate, polyarylate (PAR), polyetherimide, or a combination thereof. In some embodiments, the substrate may be a silicon wafer.

In one or more embodiments, the substrate 100 may be polyimide (PI), polyethersulphone (PES), polyacrylate (PAR), polyether imide (PEI), polyethylene naphthalate (PEN), poly(ethylene terephthalate) (PET), polyphenylene sulfide (PPS), poly(allyl), polycarbonate (PC), cellulose triacetate (TAC), cellulose acetate propionate (CAP), a cyclic olefin polymer, or a cyclic olefin copolymer.

The light-emitting device layer is arranged on the substrate 100.

The light-emitting device layer includes at least one light-emitting device 10. When there are two or more light-emitting devices 10, the two or more light-emitting devices 10 may be identical to or different from each other.

The light-emitting device 10 will be described in more detail hereinbelow.

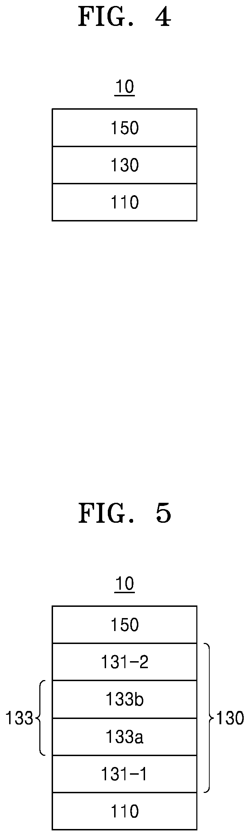

### Description of FIGS. 4 and 5

FIGS. 4 and 5 each show a schematic cross-sectional view of a light-emitting device 10 according to one or more embodiments. The light-emitting device 10 includes a first electrode 110, a second electrode 150 facing the first electrode, and an interlayer 130 arranged between the first electrode 110 and the second electrode 150.

Hereinafter, a structure of the light-emitting device 10 according to one or more embodiments and a method of manufacturing the light-emitting device 10 will be described in further detail in connection with FIGS. 4 and 5.

### First electrode 110

In FIGS. 4 and 5, a substrate may be additionally arranged under a first electrode 110 or above a second electrode 150. As the substrate, a glass substrate or a plastic substrate may be used. In one or more embodiments, the substrate may be a flexible substrate, and may include plastics with excellent heat resistance and durability, such as polyimide, polyethylene terephthalate (PET), polycarbonate, polyethylene naphthalate, polyarylate (PAR), polyetherimide, or a combination thereof.

The first electrode 110 may be formed by, for example, depositing or sputtering a material for forming the first electrode 110 on the substrate. When the first electrode 110 is an anode, a material for forming the first electrode 110 may be a high work function material that facilitates injection of holes.

The first electrode 110 may be a light reflective electrode, a semi-transmissive (i.e., a semi-light reflective) electrode, or a light transmissive (i.e., a non-light reflective) electrode. When the first electrode 110 is a transmissive electrode, a material for forming the first electrode 110 may include a conductive metal oxide such as indium tin oxide (ITO), indium zinc oxide (IZO), tin oxide (SnO₂), zinc oxide (ZnO), or a combination thereof. In one or more embodiments, when the first electrode 110 is a semi-transmissive electrode or a reflective electrode, magnesium (Mg), silver (Ag), aluminium (Al), aluminium-lithium (Al-Li), calcium (Ca), magnesium-indium (Mg-In), magnesium-silver (Mg-Ag), or a combination thereof may be used as a material for forming a first electrode.

The first electrode 110 may have a single-layer structure consisting of a single layer or a multilayer structure including a plurality of layers. For example, the first electrode 110 may have a three-layered structure of ITO/Ag/ITO.

### Interlayer 130

The interlayer 130 may be arranged on the first electrode 110. The interlayer 130 may include an emission layer.

The interlayer 130 may further include a hole transport area arranged between the first electrode 110 and the emission layer, and an electron transport area arranged between the emission layer and the second electrode 150.

The interlayer 130 may further include one or more metal-containing compounds such as organometallic compounds, inorganic materials such as quantum dots, or the like, in addition to various organic materials.

In one or more embodiments, referring to FIG. 5, the interlayer 130 may include, i) two or more emitting units 131-1 and 131-2 sequentially stacked between the first electrode 110 and the second electrode 150 and ii) a charge generation layer 133 arranged between the two emitting units. When the interlayer 130 includes the emitting units 131-1 and 131-2 and the charge generation layer 133, the light-emitting device 10 may be a tandem light-emitting device.

Two or more emitting units 131-1 and 131-2 included in the tandem light-emitting device may emit light having maximum emission wavelengths that are identical to or different from each other.

In one or more embodiments, the tandem light-emitting device may include two or more emitting units each emitting a blue light.

The "charge generation layer" may generate electrons with respect to one emitting unit of two neighboring emitting units and thus acts as a cathode, and may generate holes with respect to the other emitting unit and thus acts as an anode. The charge generation layer is not directly connected to an electrode, and may separate neighboring emitting units. Also provided is a light-emitting device including a plurality of emitting units and a plurality of charge generation layers. For example, a light-emitting device may include m emitting units may include m-1 charge generation layers.

The charge generation layer 133 may include an n-type charge generation layer 133a and a p-type charge generation layer 133b. In this case, the n-type charge generation layer 133a and the p-type charge generation layer 133b may be in direct contact with each other to form an NP junction. Due to the NP junction, electrons and holes may be simultaneously generated between the n-type charge generation layer 133a and the p-type charge generation layer 133b. The generated electrons may be transferred to one of two neighboring emitting units through the n-type charge generation layer 133a. The generated holes may be transferred to one of two neighboring emitting units through the p-type charge generation layer 133b. Also, charge generation layers 133 each include the n-type charge generation layer 133a and the p-type charge generation layer 133b, and thus, the light-emitting device 10 including m-1 charge generation layers 133 includes m-1 n-type charge generation layers 133a and m-1 p-type charge generation layers 133b.

The n-type refers to n-type semiconductor characteristics, that is, the characteristics of injecting or transporting electrons. The p-type refers to p-type semiconductor characteristics, that is, the characteristics of injecting or transporting holes.

The n-type charge generation layer 133a is the same as described in connection with an electron transport area in the present specification, and the p-type charge generation layer 133b is the same as described in connection with the hole transport area in the present specification.

A maximum emission wavelength of light emitted from at least one emitting unit of the m emitting units may be different from a maximum emission wavelength of light emitted from at least one emitting unit of the remaining emitting units. In one or more embodiments, in a light-emitting device in which a first emitting unit and a second emitting unit are stacked, a maximum emission wavelength of light emitted from the first emitting unit may be different from a maximum emission wavelength of light emitted from the second emitting unit. In this case, an emission layer of the first emitting unit and an emission layer of the second emitting unit may each independently have i) a single-layer structure consisting of a single layer, wherein the single layer consists of a single material, ii) a single-layer structure consisting of a single layer, wherein the single layer consists of a plurality of different materials, and iii) a multi-layer structure having a plurality of layers, wherein each layer consists of a single material or a plurality of different materials. Accordingly, the light emitted from the first emitting unit or the second emitting unit may be a single color light or a mixed color light. In one or more embodiments, in a light-emitting device in which a first emitting unit, a second emitting unit, and a third emitting unit are stacked, a maximum emission wavelength of a first color light emitted from the first emitting unit may be the same as a maximum emission wavelength of a second color light emitted from the second emitting unit but different from a maximum emission wavelength of a third color light emitted from the third emitting unit. In one or more embodiments, a maximum emission wavelength of the first color light emitted from the first emitting unit, a maximum emission wavelength of the second color light emitted from the second emitting unit, and a maximum emission wavelength of third color light emitted from the third emitting unit may be different from one another.

### Hole transport area in interlayer 130

The hole transport area may have: i) a single-layer structure consisting of a single layer, wherein the single layer consists of a single material, ii) a single-layer structure consisting of a single layer, wherein the single layer consists of a plurality of different materials, or iii) a multi-layer structure including a plurality of layers, wherein each layer consists of a single material or a plurality of materials.

The hole transport area may include a hole injection layer, a hole transport layer, an emission auxiliary layer, an electron blocking layer, or a combination thereof.

For example, the hole transport area may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, the layers of each structure being stacked sequentially from the first electrode 110, but embodiments are not limited thereto.

The hole transport area may include a compound represented by Formula 201, a compound represented by Formula 202, or a combination thereof: 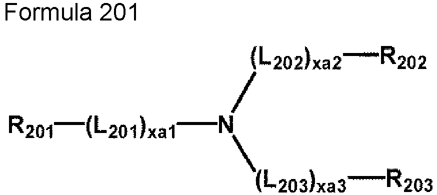 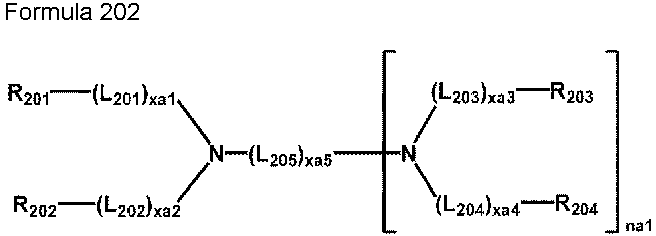 wherein, in Formulae 201 and 202,
L₂₀₁ to L₂₀₄ may each independently be a C₃-C₆₀ (*e.g*. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
L₂₀₅ may be *-0-*', *-S-*', *-N(Q₂₀₁)-*', a C₁-C₂₀ (*e.g.* C₁-C₁₀) alkylene group unsubstituted or substituted with at least one R₁₀ₐ, a C₂-C₂₀ (*e.g.* C₂-C₁₀) alkenylene group unsubstituted or substituted with at least one R₁₀ₐ, a C₃-C₆₀ (*e.g*. C₃-C₃₀) carbocyclic group unsubstituted or substituted with at least one R₁₀ₐ, or a C₁-C₆₀ (*e.g.* C₁-C₂₀) heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ (*e.g*. C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
R₂₀₁ and R₂₀₂ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ (*e.g.* C₃-C₃₀) polycyclic group (for example, a carbazole group or the like) unsubstituted or substituted with at least one R₁₀ₐ (for example, Compound HT16),
R₂₀₃ and R₂₀₄ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ (e.g. C₃-C₃₀) polycyclic group unsubstituted or substituted with at least one R₁₀ₐ, and
na1 may be an integer from 1 to 4.

In one or more embodiments, each of Formulae 201 and 202 may include at least one group represented by Formulae CY201 to CY217.

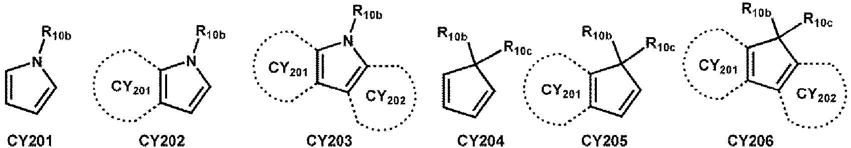

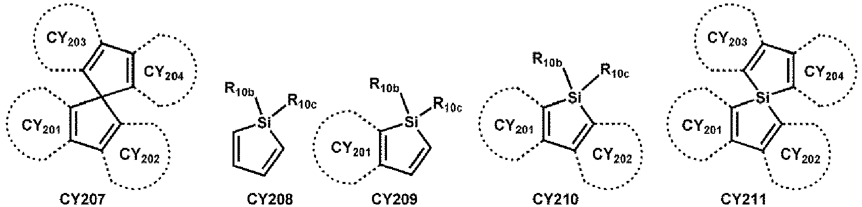

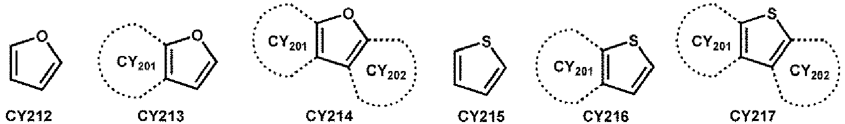

R_{10b} and R_{10c} in Formulae CY201 to CY217 are respectively as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ as described herein.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one group represented by Formulae CY201 to CY203.

In one or more embodiments, Formula 201 may include at least one group represented by Formulae CY201 to CY203 and at least one group represented by Formulae CY204 to CY217.

In one or more embodiments, xa1 in Formula 201 may be 1, R₂₀₁ may be a group represented by one or more of Formulae CY201 to CY203, xa2 may be 0, and R₂₀₂ may be a group represented by one or more of Formulae CY204 to CY207.

In one or more embodiments, each of Formulae 201 and 202 may not include groups represented by Formulae CY201 to CY203.

In one or more embodiments, each of Formulae 201 and 202 may not include groups represented by Formulae CY201 to CY203, and may include at least one group represented by Formulae CY204 to CY217.

In one or more embodiments, each of Formulae 201 and 202 may not include groups represented by Formulae CY201 to CY217.

In one or more embodiments, the hole transport area may include at least one of Compounds HT1 to HT44, 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(naphthalene-1-yl)-N,N'-diphenyl-benzidine (NPB, also referred to as NPD), β-NPB, N,N'-bis(3-methylphenyl)-N,N'-diphenyl-[1,1-biphenyl]-4,4'-diamine (TPD), Spiro-TPD, Spiro-NPB, methylated NPB, 4,4'-cyclohexylidene bis[N,N-bis(4-methylphenyl)benzidene (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or a combination thereof:

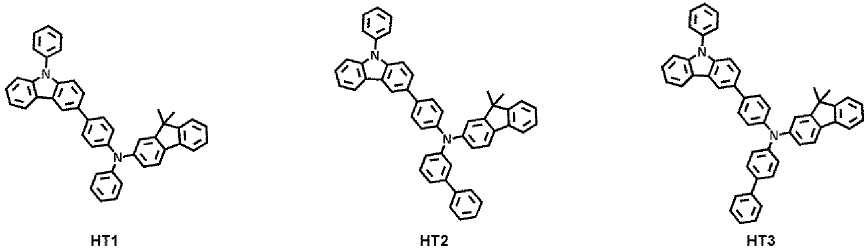

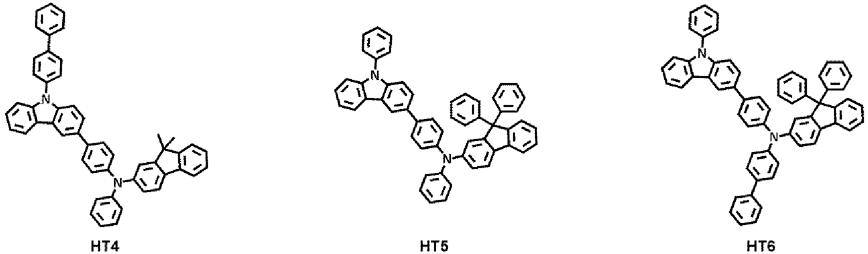

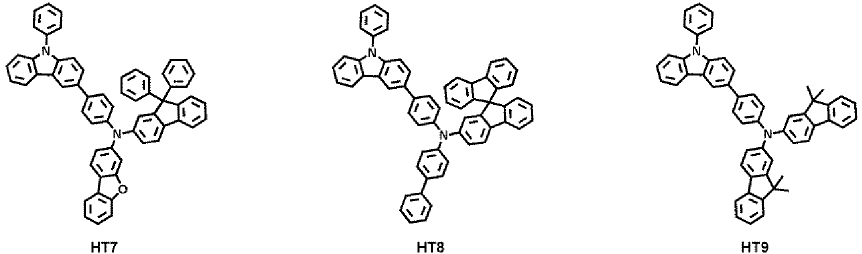

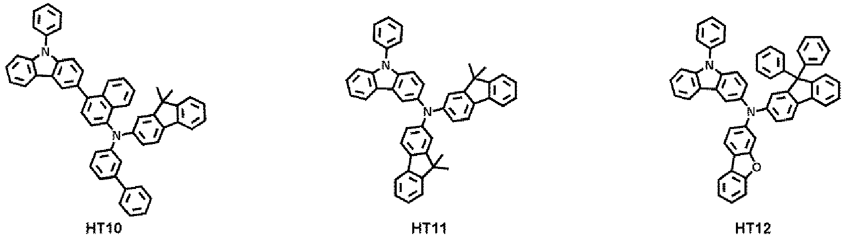

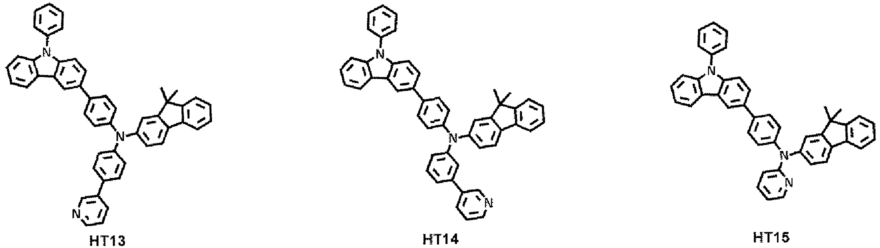

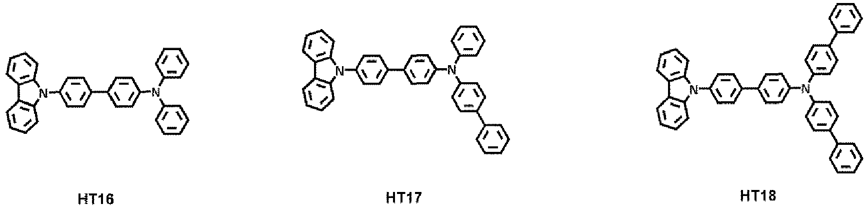

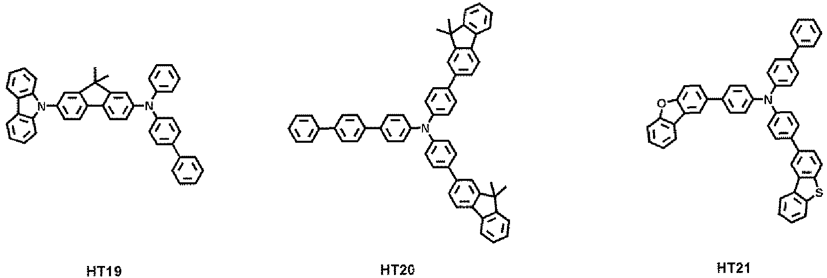

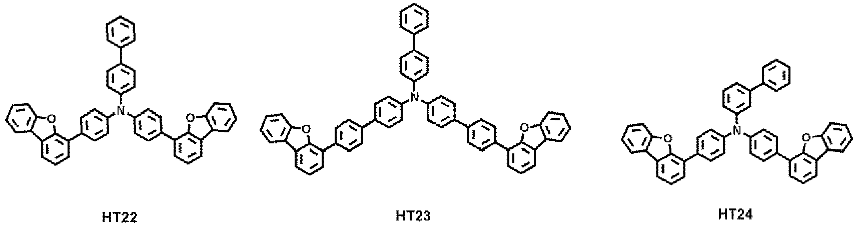

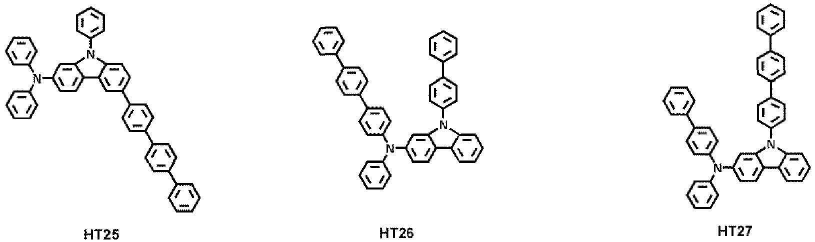

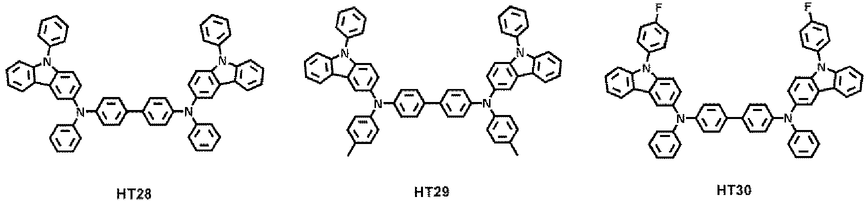

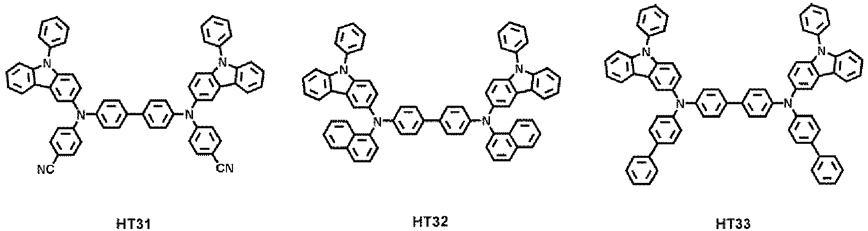

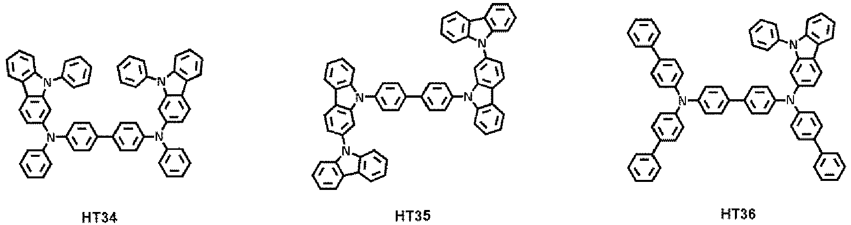

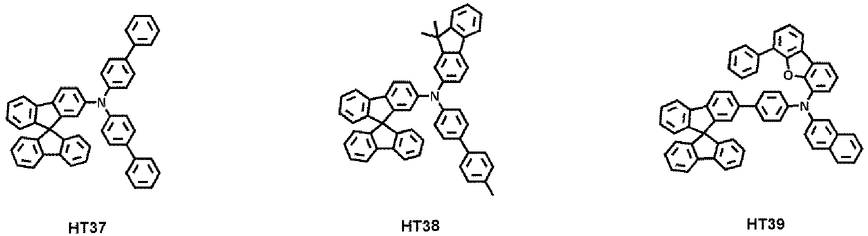

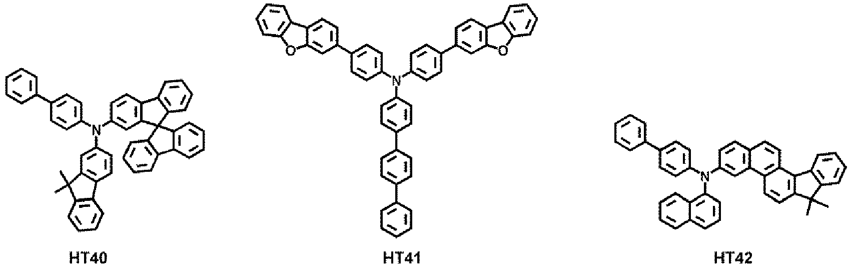

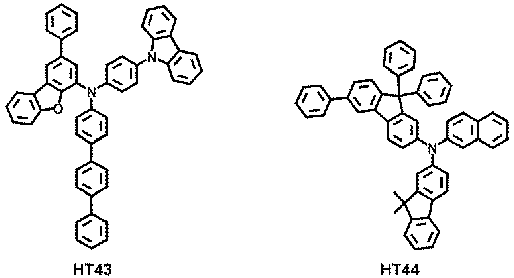

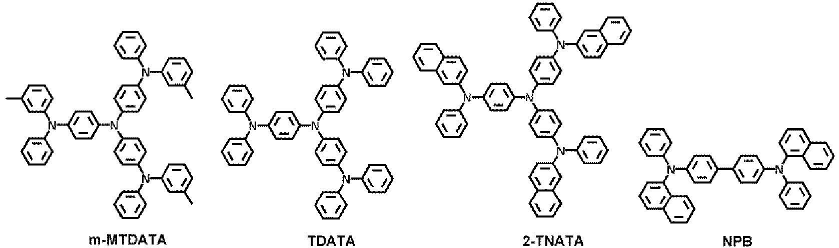

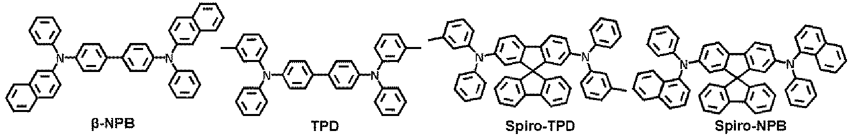

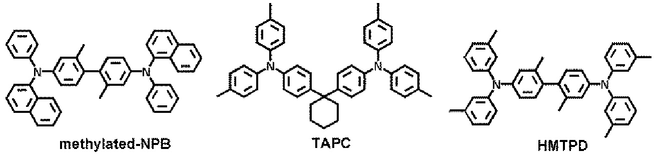

A thickness of the hole transport area may be in a range of about 50 angstroms (Å) to about 10,000 Å, for example, about 100 Å to about 4,000 Å. When the hole transport area includes a hole injection layer, a hole transport layer, or a combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport area, the hole injection layer and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block the flow of electrons from an electron transport area. The emission auxiliary layer and the electron blocking layer may include the materials as described above.

### p-dopant

The hole transport area may further include, in addition to these materials, a charge-generation material for the improvement of conductive properties. The charge-generation material may be uniformly or non-uniformly dispersed in the hole transport area (for example, in the form of a single layer consisting of a charge-generation material).

The charge-generation material may be, for example, a p-dopant.

In one or more embodiments, a lowest unoccupied molecular orbital (LUMO) energy level of the p-dopant may be about -3.5 eV or less.

In one or more embodiments, the p-dopant may include a quinone derivative, a cyano group-containing compound, a compound containing element EL1 and element EL2, or a combination thereof.

Examples of the quinone derivative may include TCNQ, F4-TCNQ, or the like.

Examples of the cyano group-containing compound may include HAT-CN, a compound represented by Formula 221 below, or the like.

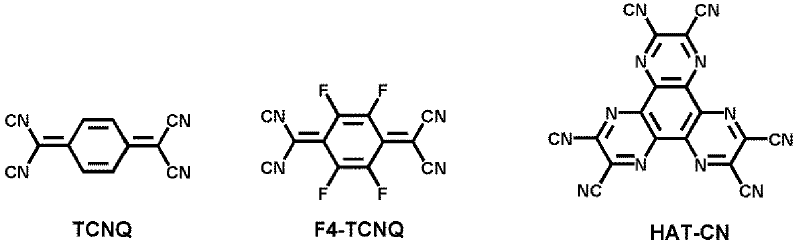

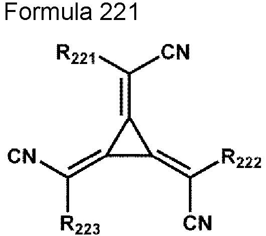

In Formula 221,
R₂₂₁ to R₂₂₃ may each independently be a C₃-C₆₀ (*e.g*. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ, and
at least one of R₂₂₁ to R₂₂₃ may each independently be a C₃-C₆₀ (*e.g*. C₃-C₃₀) carbocyclic group or a C₁-C₆₀ (*e.g.* C₁-C₂₀) heterocyclic group, each substituted with at least one of a cyano group; -F; -Cl; -Br; -I; a C₁-C₂₀ alkyl group substituted with a cyano group, -F, -Cl, -Br, -I, or a combination thereof; or a combination thereof.

In the compound containing element EL1 and element EL2, element EL1 may be a metal, a metalloid, or a combination thereof, and element EL2 may be non-metal, a metalloid, or a combination thereof.

Examples of the metal may include: an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.), or an alloy thereof.

Examples of the metalloid may include silicon (Si), antimony (Sb), germanium (Ge), arsenic (As), tellurium (Te), or an alloy thereof.

Examples of the non-metal may include oxygen (O), a halogen (for example, F, Cl, Br, I, etc.), or a combination thereof.

In one or more embodiments, examples of the compound containing element EL1 and element EL2 may include metal oxide, metal halide (for example, metal fluoride, metal chloride, metal bromide, or metal iodide), metalloid halide (for example, metalloid fluoride, metalloid chloride, metalloid bromide, or metalloid iodide), metal telluride, or a combination thereof.

Examples of the metal oxide may include a tungsten oxide (for example, WO, W₂O₃, WO₂, WO₃, W₂O₅, etc.), a vanadium oxide (for example, VO, V₂O₃, VO₂, V₂O₅, etc.), a molybdenum oxide (MoO, Mo₂O₃, MoO₂, MoO₃, Mo₂O₅, etc.), a rhenium oxide (for example, ReO₃, etc.), or a combination thereof.

Examples of the metal halide may include alkali metal halide, alkaline earth metal halide, transition metal halide, post-transition metal halide, lanthanide metal halide, or a combination thereof.

Examples of the alkali metal halide may include LiF, NaF, KF, RbF, CsF, LiCl, NaCl, KCI, RbCl, CsCl, LiBr, NaBr, KBr, RbBr, CsBr, Lil, Nal, Kl, Rbl, Csl, or a combination thereof.

Examples of the alkaline earth metal halide may include BeF₂, MgF₂, CaF₂, SrF₂, BaF₂, BeCl₂, MgCl₂, CaCl₂, SrCl₂, BaCl₂, BeBr2, MgBr₂, CaBr₂, SrBr2, BaBr2, BeI₂, MgI₂, Cal₂, Srl₂, BaI₂, or a combination thereof.

Examples of the transition metal halide may include a titanium halide (for example, TiF₄, TiCl₄, TiBr₄, TiI₄, etc.), a zirconium halide (for example, ZrF₄, ZrCl₄, ZrBr₄, ZrI₄, etc.), a hafnium halide (for example, HfF₄, HfCl₄, HfBr₄, HfI₄, etc.), a vanadium halide (for example, VF₃, VCl₃, VBr₃, VI₃, etc.), a niobium halide (for example, NbF₃, NbCl₃, NbBr₃, Nbl₃, etc.), a tantalum halide (for example, TaF₃, TaCl₃, TaBr₃, TaI₃, etc.), a chromium halide (for example, CrF₃, CrCl₃, CrBr₃, CrI₃, etc.), a molybdenum halide (for example, MoF₃, MoCl₃, MoBr₃, MoI₃, etc.), a tungsten halide (for example, WF₃, WCl₃, WBr₃, WI₃, etc.), a manganese halide (for example, MnF₂, MnCl₂, MnBr₂, MnI₂, etc.), a technetium halide (for example, TcF₂, TcCl₂, TcBr₂, TcI₂, etc.), a rhenium halide (for example, ReF₂, ReCl₂, ReBr₂, ReI₂, etc.), an iron halide (for example, FeF₂, FeCl₂, FeBr₂, FeI₂, etc.), a ruthenium halide (for example, RuF₂, RuCl₂, RuBr₂, RuI₂, etc.), an osmium halide (for example, OsF₂, OsCl₂, OsBr₂, OsI₂, etc.), a cobalt halide (for example, CoF₂, CoCl₂, CoBr₂, CoI₂, etc.), a rhodium halide (for example, RhF₂, RhCl₂, RhBr₂, RhI₂, etc.), an iridium halide (for example, IrF₂, IrCl₂, IrBr₂, IrI₂, etc.), a nickel halide (for example, NiF₂, NiCl₂, NiBr₂, NiI₂, etc.), a palladium halide (for example, PdF₂, PdCl₂, PdBr₂, PdI₂, etc.), a platinum halide (for example, PtF₂, PtCl₂, PtBr₂, PtI₂, etc.), a copper halide (for example, CuF, CuCl, CuBr, Cul, etc.), a silver halide (for example, AgF, AgCl, AgBr, Agl, etc.), a gold halide (for example, AuF, AuCl, AuBr, Aul, etc.), a hydrate thereof, or a combination thereof.

Examples of the post-transition metal halide may include a zinc halide (for example, ZnF₂, ZnCl₂, ZnBr₂, ZnI₂, etc.), an indium halide (for example, InI₃, etc.), a tin halide (for example, SnI₂, etc.), a hydrate thereof, or a combination thereof.

Examples of the lanthanide metal halide may include YbF, YbF₂, YbF₃, SmF₃, YbCl, YbCl₂, YbCl₃ SmCl₃, YbBr, YbBr₂, YbBr₃, SmBr₃, Ybl, YbI₂, YbI₃, SmI₃, a hydrate thereof, or a combination thereof.

Examples of the metalloid halide may include an antimony halide (for example, SbCl₅, etc.) or a hydrate thereof.

Examples of the metal telluride may include alkali metal telluride (for example, Li₂Te, Na₂Te, K₂Te, Rb₂Te, Cs₂Te, etc.), an alkaline earth metal telluride (for example, BeTe, MgTe, CaTe, SrTe, BaTe, etc.), a transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), a post-transition metal telluride (for example, ZnTe, etc.), a lanthanide metal telluride (for example, LaTe, CeTe, PrTe, NdTe, PmTe, EuTe, GdTe, TbTe, DyTe, HoTe, ErTe, TmTe, YbTe, LuTe, etc.), a hydrate thereof, or a combination thereof.

### Emission layer in interlayer 130

When the light-emitting device 10 is a full color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and a blue emission layer, in which the two or more layers contact each other or are separated from each other. In one or more embodiments, the emission layer may include two or more materials of a red light-emitting material, a green light-emitting material, and a blue light-emitting material, in which the two or more materials are mixed with each other in a single layer to emit white light.

A thickness of the emission layer may be in a range of about 100 Å to about 1,000 Å, for example, about 200 Å to about 600 Å. When the thickness of the emission layer is within the range, excellent light-emission characteristics may be obtained without a substantial increase in driving voltage.

### Host

The host may include a compound represented by Formula 301 below:

Formula 301 [Ar₃₀₁]_{xb11}-[(L₃₀₁)_{xb1}-R₃₀₁]_{xb21}

wherein, in Formula 301,
Ar₃₀₁ and L₃₀₁ may each independently be a C₃-C₆₀ (*e.g*. C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e.g.* C₁-C₂₀) alkyl group unsubstituted or substituted with at least one R₁₀ₐ, a C₂-C₆₀ (*e.g.* C₂-C₂₀) alkenyl group unsubstituted or substituted with at least one R₁₀ₐ, a C₂-C₆₀ (*e.g.* C₂-C₂₀) alkynyl group unsubstituted or substituted with at least one R₁₀ₐ, a C₁-C₆₀ (*e.g.* C₁-C₂₀) alkoxy group unsubstituted or substituted with at least one R₁₀ₐ, a C₁-C₆₀ (*e.g.* C₁-C₂₀) alkylthio group unsubstituted or substituted with at least one R₁₀ₐ, a C₃-C₆₀ (*e.g.* C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ,-Si(Q₃₀₁)(Q₃₀₂)(Q₃₀₃), -N(Q₃₀₁)(Q₃₀₂), - B(Q₃₀₁)(Q₃₀₂), -C(=O)(Q₃₀₁), -S(=O)₂(Q₃₀₁), -P(Q₃₀₁)(Q₃₀₂), or -P(=O)(Q₃₀₁)(Q₃₀₂),
xb21 may be an integer from 1 to 5, and
Q₃₀₁ to Q₃₀₃ are respectively as described in connection with Q₁.

In one or more embodiments, when xb11 in Formula 301 is 2 or more, two or more of Ar₃₀₁(s) may be linked to each other via a single bond.

In one or more embodiments, the host may include a compound represented by Formula 301-1, a compound represented by Formula 301-2, or a combination thereof: 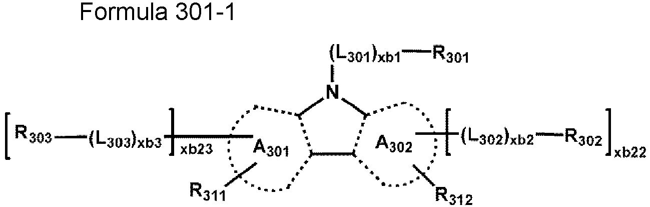 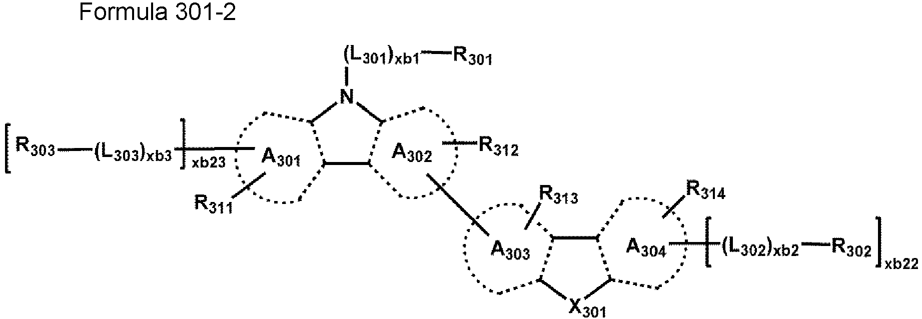 wherein, in Formulae 301-1 and 301-2,
ring A₃₀₁ to ring A₃₀₄ may each independently be a C₃-C₆₀ (*e.g*. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ are respectively as described herein,
L₃₀₂ to L₃₀₄ are each independently as described in connection with L₃₀₁,
xb2 to xb4 are each independently as described in connection with xb1, and
R₃₀₂ to R₃₀₅ and R₃₁₁ to R₃₁₄ are respectively as described in connection with R₃₀₁.

In one or more embodiments, the host may include an alkaline earth-metal complex. In one or more embodiments, the host may include a Be-containing complex (for example, Compound H55), an Mg-containing complex, a Zn-containing complex, or a combination thereof.

In one or more embodiments, the host may include at least one of Compounds H1 to H125, 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), 3,3-di(9H-carbazol-9-yl)biphenyl (mCBP), or a combination thereof:

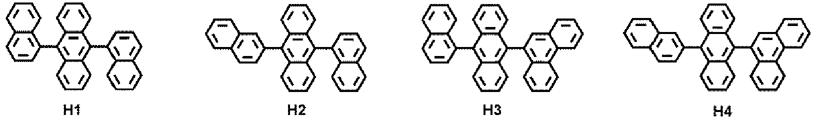

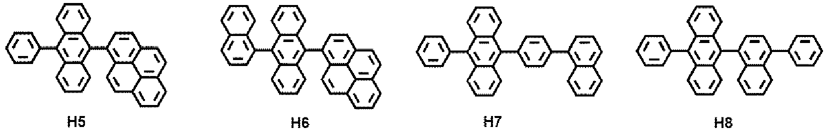

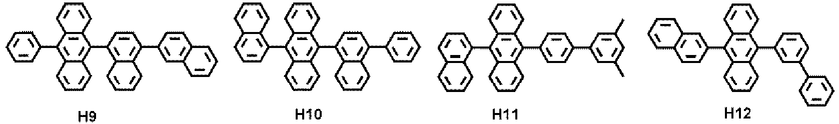

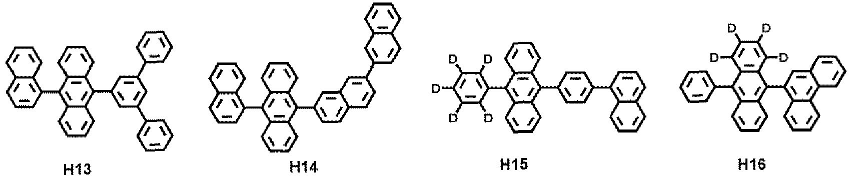

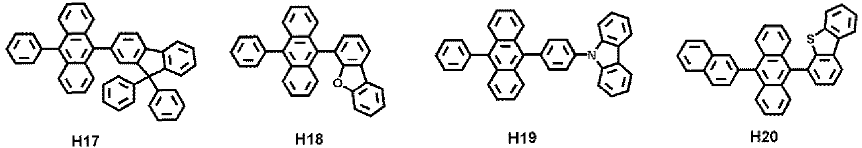

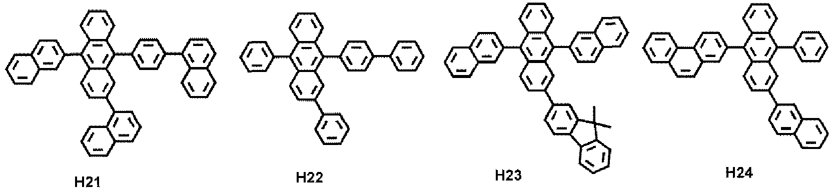

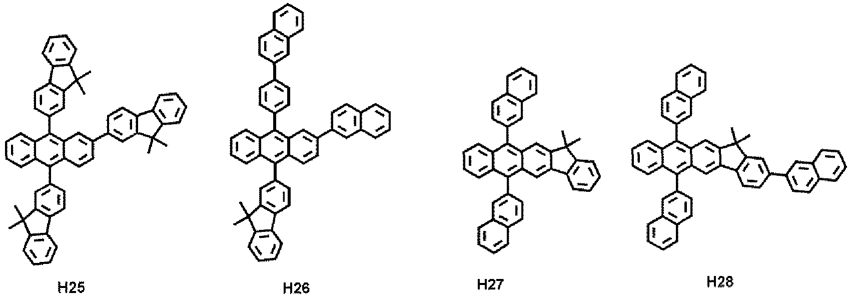

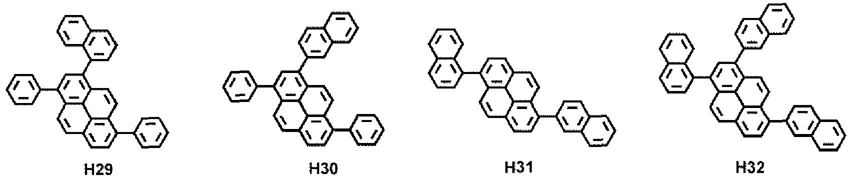

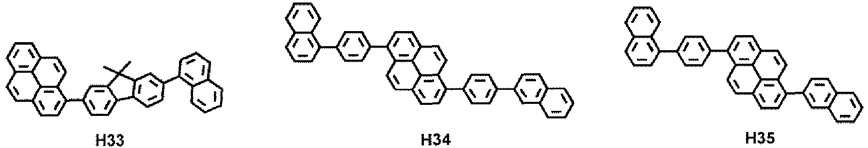

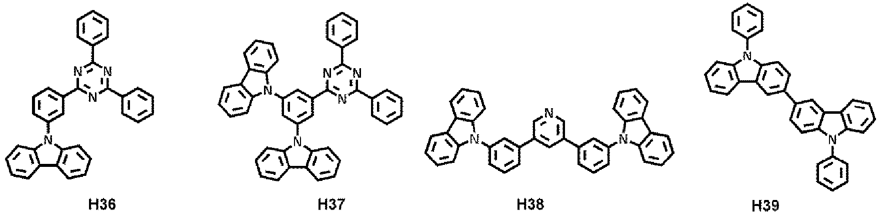

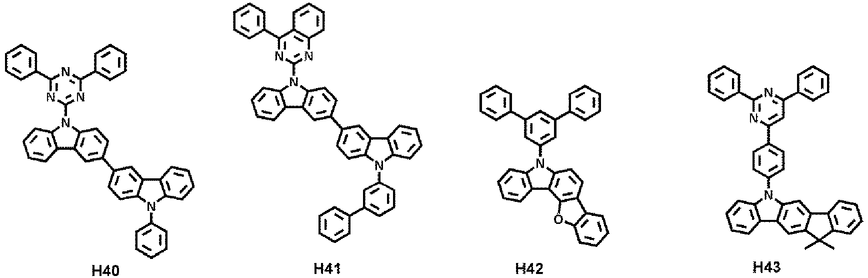

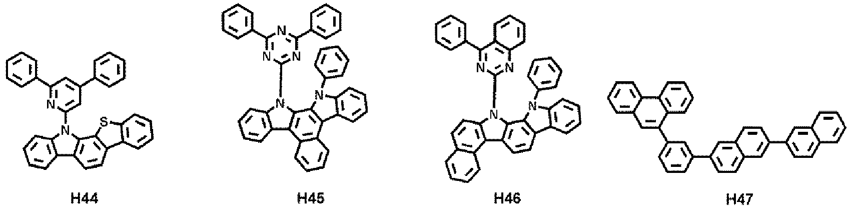

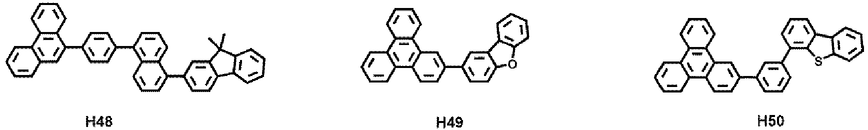

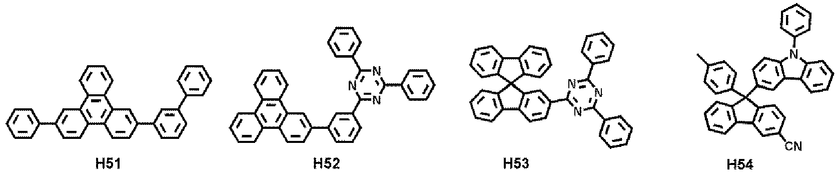

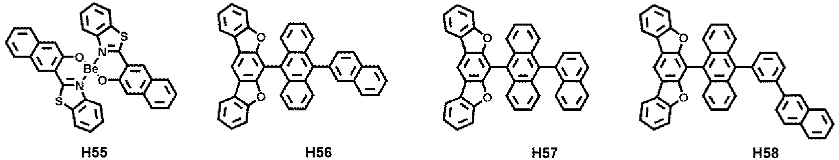

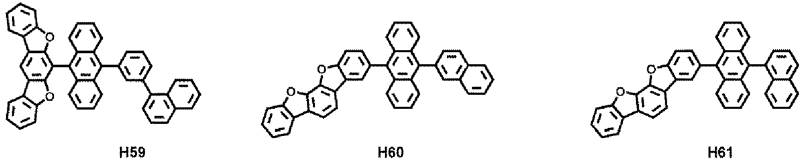

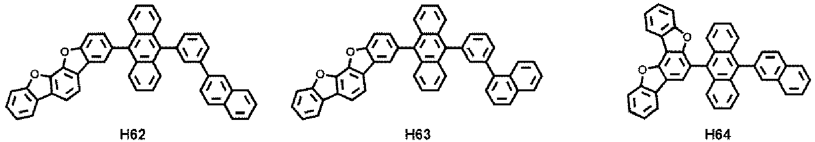

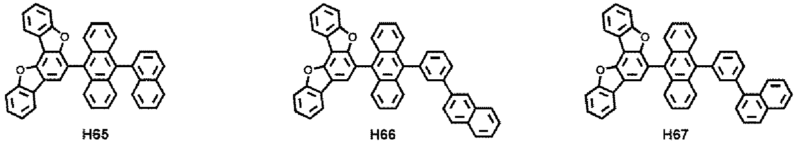

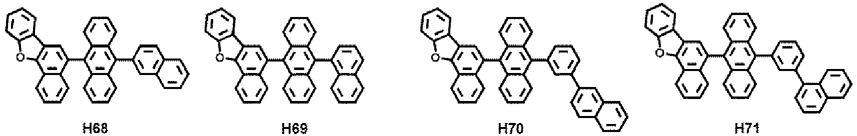

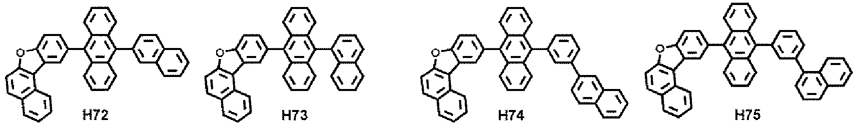

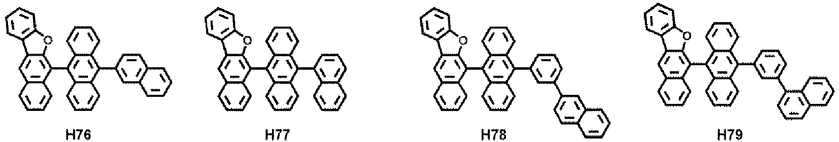

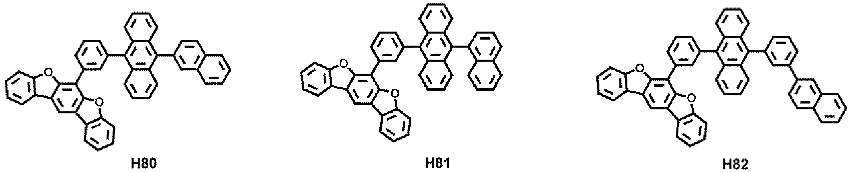

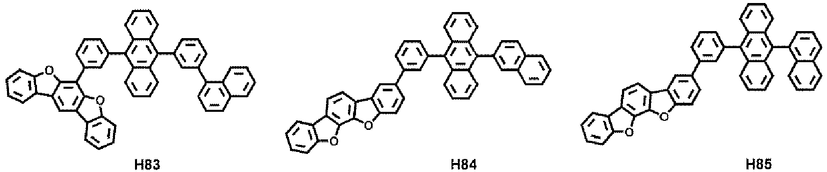

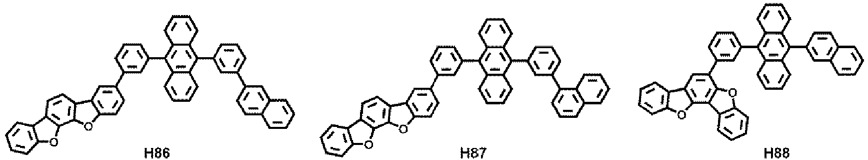

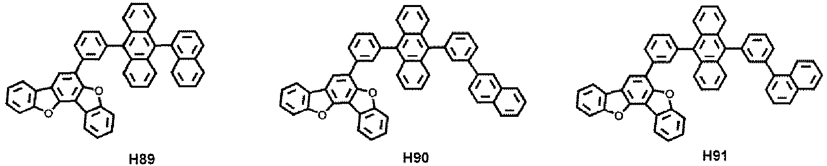

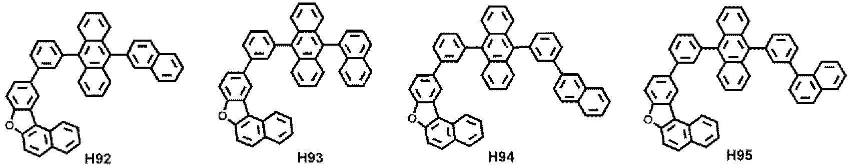

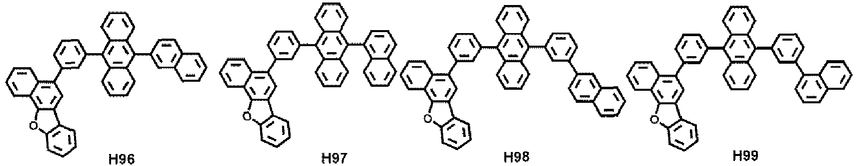

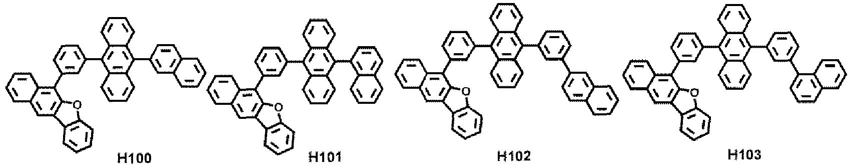

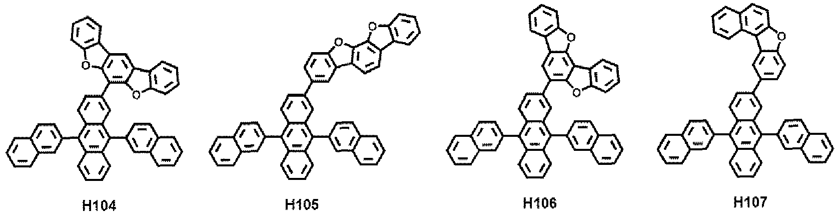

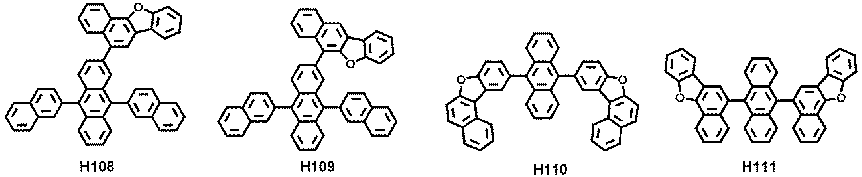

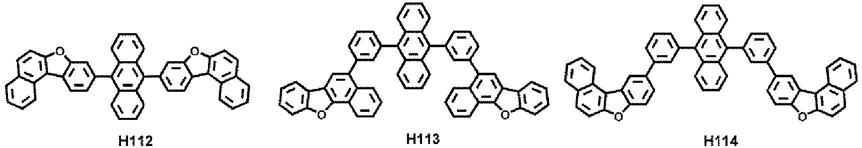

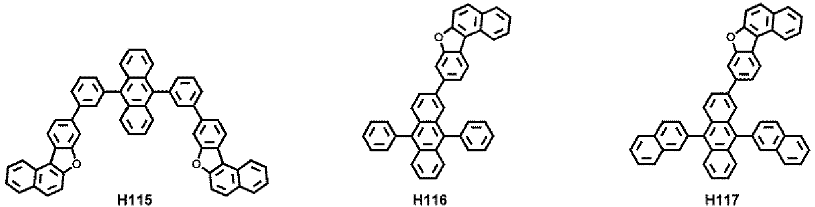

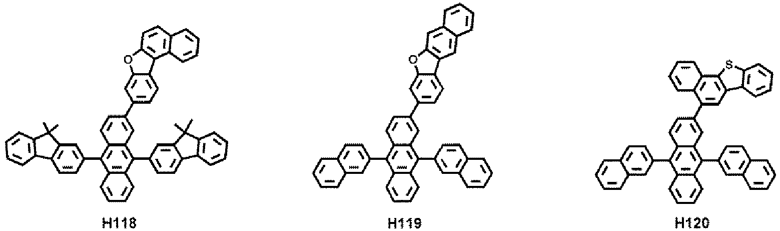

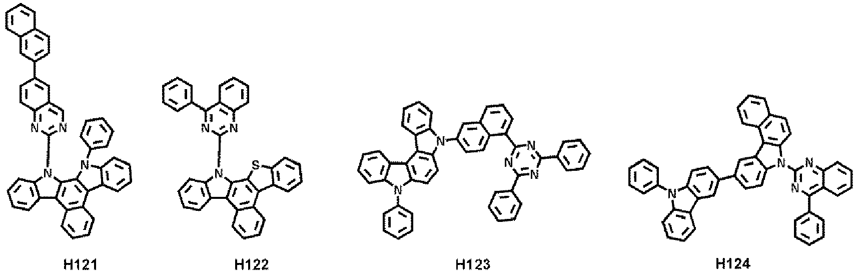

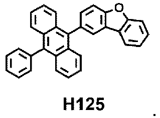

### Phosphorescent dopant

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or a combination thereof.

The phosphorescent dopant may be electrically neutral.

In one or more embodiments, the phosphorescent dopant may include an organometallic compound represented by Formula 401:

Formula 401 M(L₄₀₁)_{xc1}(L₄₀₂)_{xc2}

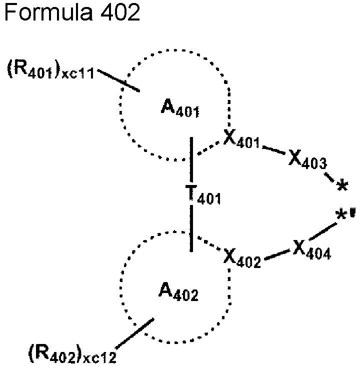

wherein, in Formulae 401 and 402,
M may be transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, when xc1 is 2 or 3, two or more of L₄₀₁(s) may be identical to or different from each other,
L₄₀₂ may be an organic ligand, and xc2 may be 0, 1, 2, 3, or 4, wherein, when xc2 is 2, 3, or 4, two or more of L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ (*e.g*. C₃-C₃₀) carbocyclic group or a C₁-C₆₀ (*e.g.* C₁-C₂₀) heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordinate bond), -O-, -S-, -N(Q₄₁₃)-, -B(Q₄₁₃)-, -P(Q₄₁₃)-, -C(Q₄₁₃)(Q₄₁₄)-, or - Si(Q₄₁₃)(Q₄₁₄)-,
Q₄₁₁ to Q₄₁₄ are respectively as described in connection with Q₁,
R₄₀₁ and R₄₀₂ may each independently be hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group unsubstituted or substituted with at least one R₁₀ₐ, a C₁-C₂₀ alkoxy group unsubstituted or substituted with at least one R₁₀ₐ, a C₁-C₂₀ alkylthio group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), - C(=O)(Q₄₀₁), -S(=O)₂(Q₄₀₁), -P(Q₄₀₁)(Q₄₀₂), or -P(=O)(Q₄₀₁)(Q₄₀₂),
Q₄₀₁ to Q₄₀₃ are respectively as described in connection with Q₁,
xc11 and xc12 may each independently be an integer from 0 to 10, and
* and *' in Formula 402 each indicate a binding site to M in Formula 401.

In one or more embodiments, in Formula 402, i) X₄₀₁ may be nitrogen, and X₄₀₂ may be carbon, or ii) each of X₄₀₁ and X₄₀₂ may be nitrogen.

In one or more embodiments, when xc1 in Formula 401 is 2 or 3, two rings A₄₀₁ in two or more of L₄₀₁(s) may be optionally linked to each other via T₄₀₂, which is a linking group, and two ring A₄₀₂ may optionally be linked to each other via T₄₀₃, which is a linking group (see Compounds PD1 to PD4 and PD7). T₄₀₂ and T₄₀₃ are respectively as described in connection with T₄₀₁.

L₄₀₂ in Formula 401 may be an organic ligand. In one or more embodiments, L₄₀₂ may include a halogen group, a diketone group (for example, an acetylacetonate group), a carboxylic acid group (for example, a picolinate group), a carbonyl (-C=O) group, an isonitrile group, -CN group, a phosphorus group (for example, a phosphine group, a phosphite group, etc.), or a combination thereof.

The phosphorescent dopant may include, for example, at least one of compounds PD1 to PD39, or a combination thereof:

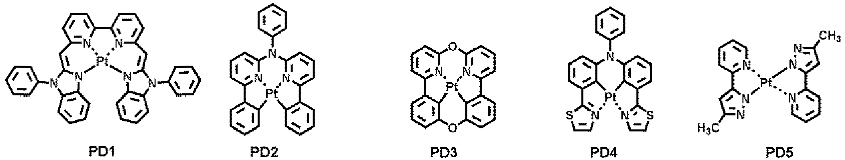

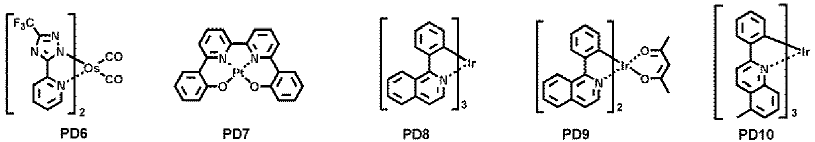

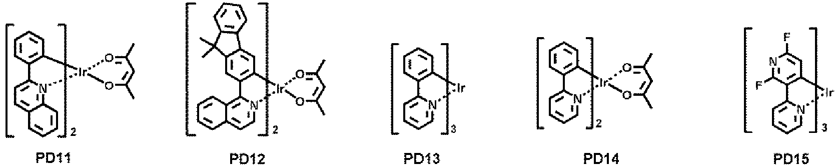

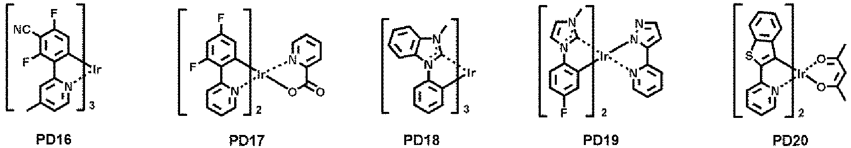

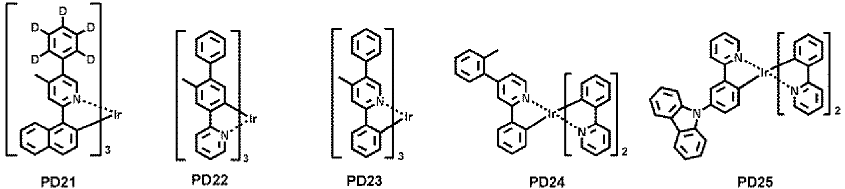

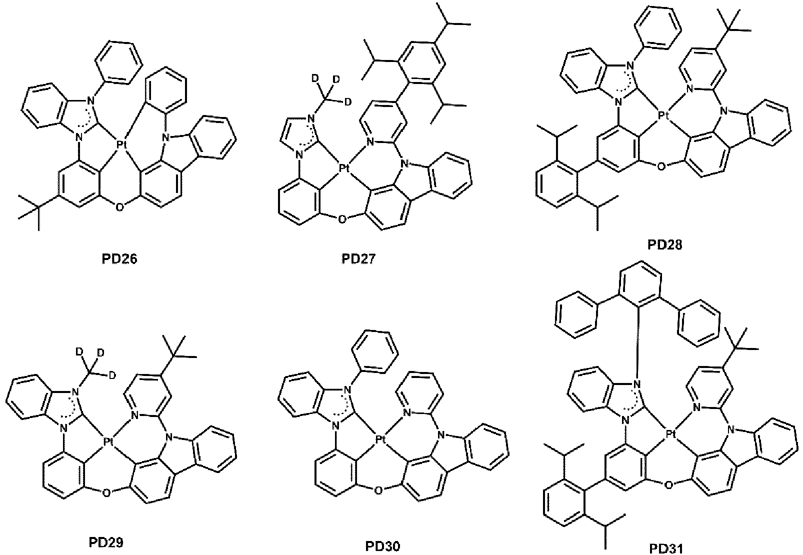

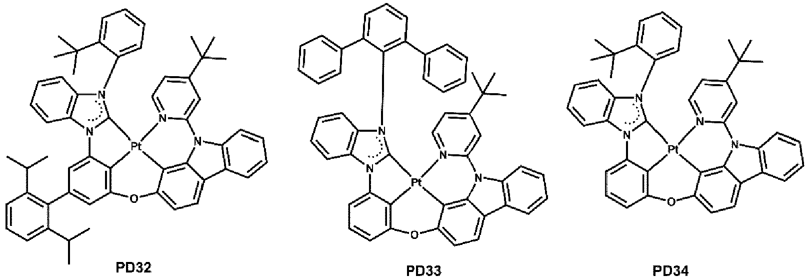

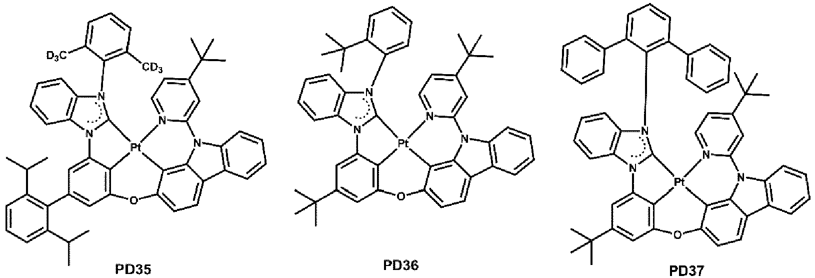

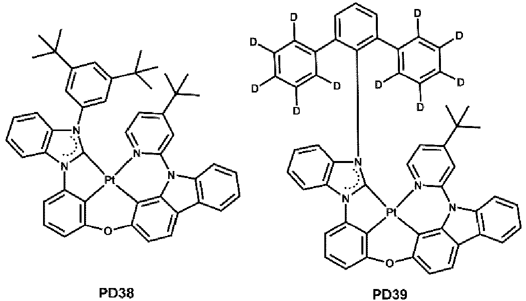

### Fluorescent dopant

The fluorescent dopant may include an amine group-containing compound, a styryl group-containing compound, or a combination thereof.

In one or more embodiments, the fluorescent dopant may include a compound represented by Formula 501: 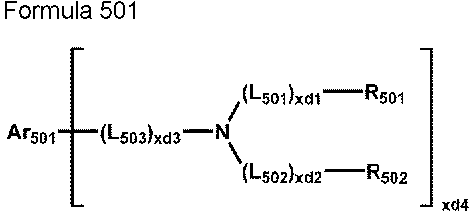 wherein, in Formula 501,
Ar₅₀₁, L₅₀₁ to L₅₀₃, R₅₀₁, and R₅₀₂ may each independently be a C₃-C₆₀ (*e.g*. C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
xd1 to xd3 may each independently be 0, 1, 2, or 3, and
xd4 may be 1, 2, 3, 4, 5, or 6.

In one or more embodiments, Ar₅₀₁ in Formula 501 may be a condensed cyclic group (for example, an anthracene group, a chrysene group, or a pyrene group) in which three or more monocyclic groups are condensed together.

In one or more embodiments, xd4 in Formula 501 may be 2.

In one or more embodiments, the fluorescent dopant may include: at least one of Compounds FD1 to FD37; DPVBi; DPAVBi; or a combination thereof:

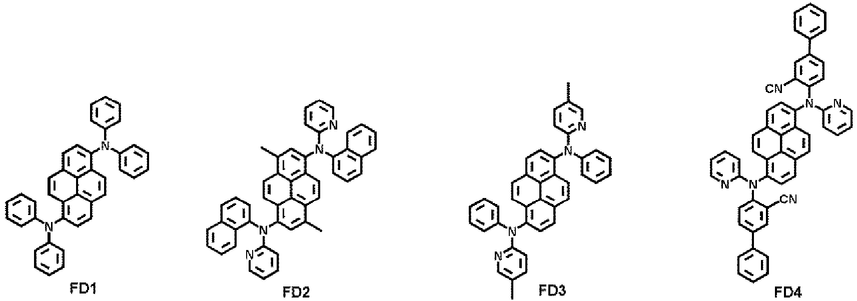

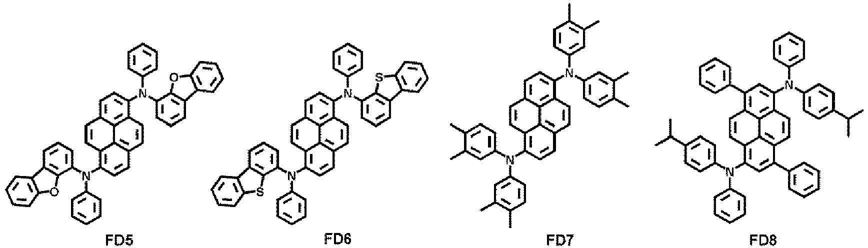

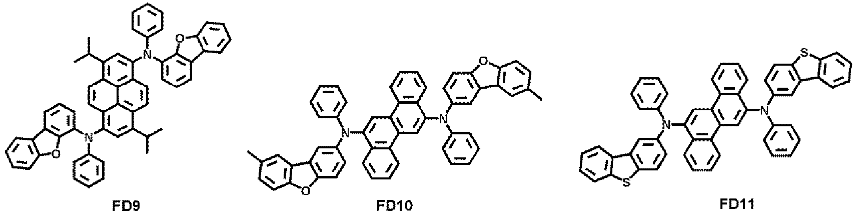

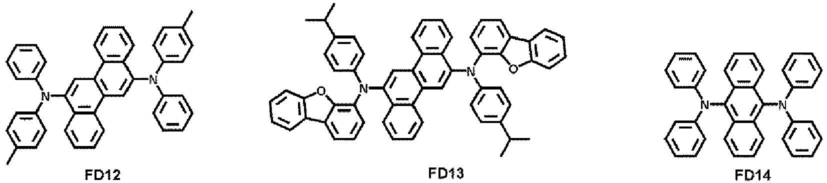

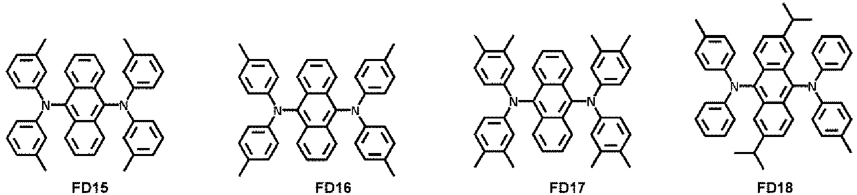

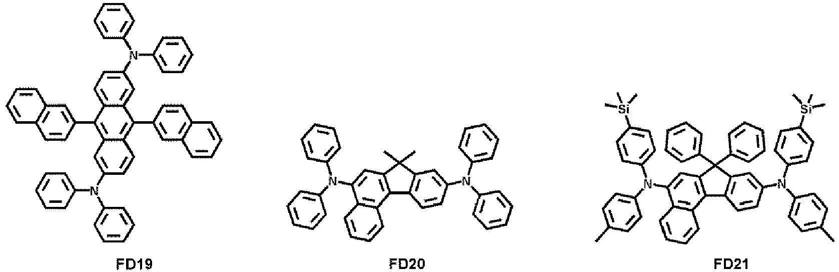

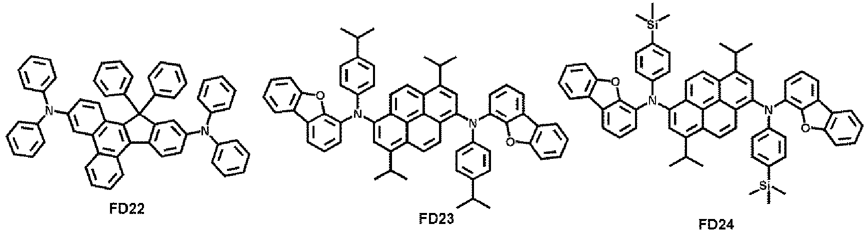

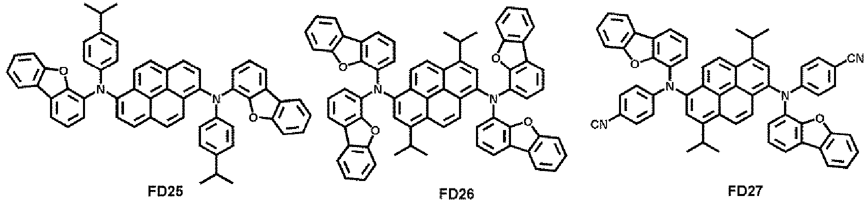

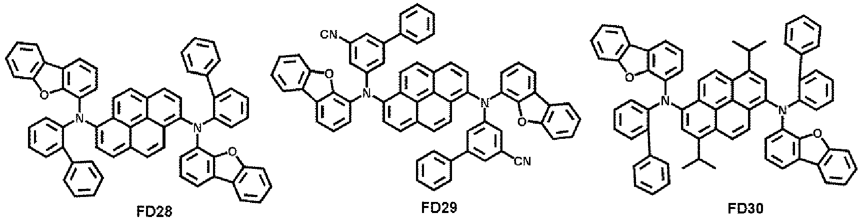

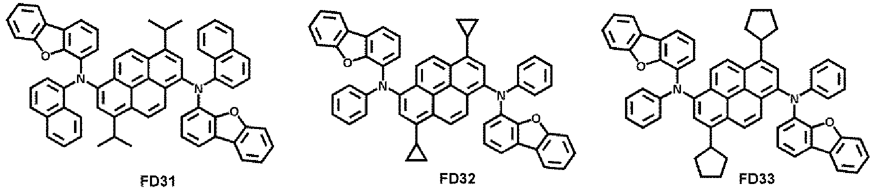

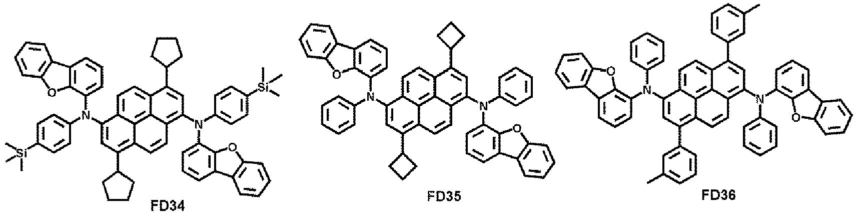

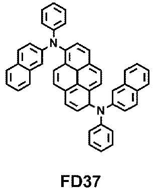

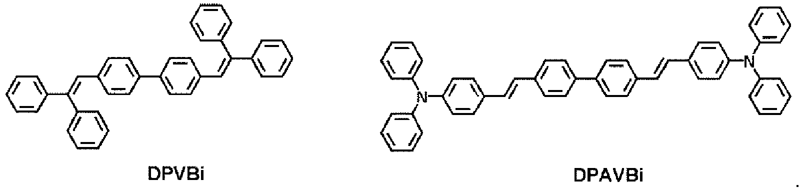

### Delayed fluorescence material

The emission layer may include a delayed fluorescence material.

In one or more embodiments, the delayed fluorescence material may be chosen from compounds capable of emitting delayed fluorescence based on a delayed fluorescence emission mechanism.

The delayed fluorescence material included in the emission layer may act as a host or a dopant depending on the type of other materials included in the emission layer.

In one or more embodiments, the difference between the first excited triplet (T₁) energy level (electron volts, eV) of the delayed fluorescence material and the first excited singlet (S₁) energy level (eV) of the delayed fluorescence material may be greater than or equal to 0 eV and less than or equal to 0.5 eV, for example, from 0.05 to 0.45 eV, or from 0.1 to 0.4 eV. Without wishing to be bound to theory, when the energy difference between the triplet (T₁) energy level (eV) of the delayed fluorescence material and the singlet (S₁) energy level (eV) of the delayed fluorescence material satisfies the above-described range, up-conversion from the triplet state to the singlet state of the delayed fluorescence materials may effectively occur, and thus, the luminescence efficiency of the light-emitting device 10 may be improved.

In one or more embodiments, the delayed fluorescence material may include i) a material including at least one electron donor (for example, a π electron-rich C₃-C₆₀ (*e.g*. C₃-C₃₀) cyclic group, such as a carbazole group) and at least one electron acceptor (for example, a sulfoxide group, a cyano group, or a π electron-deficient nitrogen-containing C₁-C₆₀ (*e.g.* C₁-C₃₀) cyclic group), and ii) a material including a C₈-C₆₀ (*e.g.* C₃-C₃₀) polycyclic group in which two or more cyclic groups are condensed while sharing a boron (B) atom.

Examples of the delayed fluorescence material may include at least one of the following compounds DF1 to DF11, or a combination thereof:

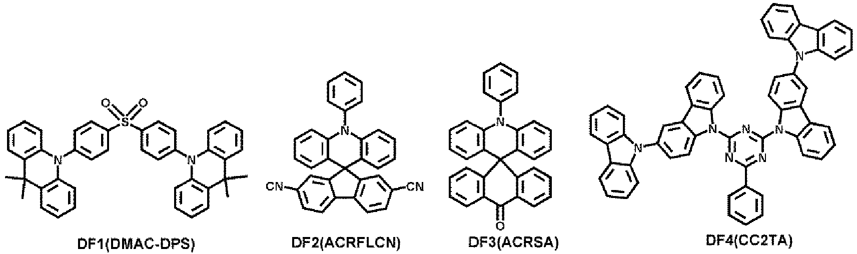

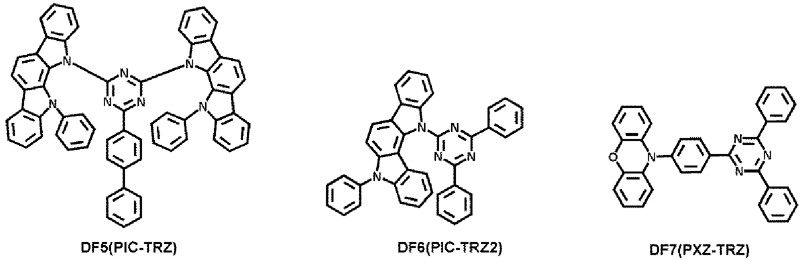

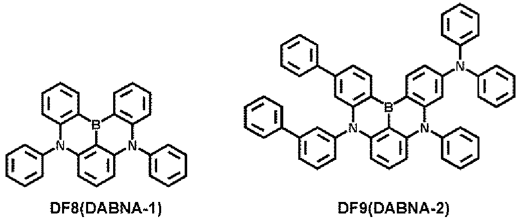

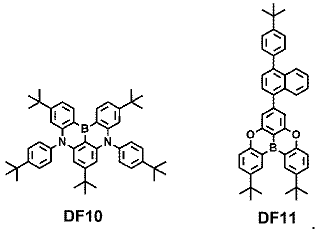

### Quantum Dot

The emission layer may include a quantum dot.

In the present specification, a quantum dot refers to a crystal of a semiconductor compound, and may include any material capable of emitting light of various emission wavelengths according to the size of the crystal.

An average diameter (D50) of the quantum dot may be, for example, in a range of about 1 nm to about 10 nm, or of about 1 nm to about 8 nm, or of about 1 nm to about 6 nm.

The quantum dot may be synthesized by a wet chemical process, a metal organic chemical vapor deposition process, a molecular beam epitaxy process, or a suitable process similar thereto.

According to the wet chemical process, a precursor material is mixed with an organic solvent to grow a quantum dot particle crystal. When the crystal is grown, the organic solvent may act as a dispersant if it becomes coordinated on the surface of the quantum dot crystal, which may help to control the growth of the crystal so that the growth of quantum dot particles may be controlled through a process which is easier and/or more efficient than vapor deposition methods, such as metal organic chemical vapor deposition (MOCVD) or molecular beam epitaxy (MBE), and which may be performed at substantially lower costs.

The quantum dot may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or a combination thereof.

Examples of the Group II-VI semiconductor compound may include: a binary compound, such as CdSe, CdTe, ZnS, ZnSe, ZnTe, ZnO, HgS, HgSe, HgTe, MgSe, or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound, such as CdZnSeS, CdZnSeTe, CdZnSTe, CdHgSeS, CdHgSeTe, CdHgSTe, HgZnSeS, HgZnSeTe, or HgZnSTe; or a combination thereof.

Examples of the Group III-V semiconductor compound may include: a binary compound, such as GaN, GaP, GaAs, GaSb, AIN, AlP, AlAs, AlSb, InN, InP, InAs, or InSb; a ternary compound, such as GaNP, GaNAs, GaNSb, GaPAs, GaPSb, AINP, AlNAs, AlNSb, AlPAs, AlPSb, InGaP, InNP, InAlP, InNAs, InNSb, InPAs, or InPSb; a quaternary compound, such as GaAlNP, GaAINAs, GaAINSb, GaAlPAs, GaAlPSb, GalnNP, GalnNAs, GalnNSb, GalnPAs, GalnPSb, InAlNP, InAlNAs, InAlNSb, InAlPAs, or InAlPSb; or a combination thereof. In one or more embodiments, the Group III-V semiconductor compound may further include Group II elements. Examples of the Group III-V semiconductor compound further including Group II elements may include InZnP, InGaZnP, InAlZnP, and the like.

Examples of the Group III-VI semiconductor compound may include: a binary compound, such as GaS, GaSe, Ga₂Se₃, GaTe, InS, InSe, In₂S₃, In₂Se₃, or InTe; a ternary compound, such as InGaS₃, or InGaSe₃; or a combination thereof.

Examples of the Group I-III-VI semiconductor compound may include: a ternary compound, such as AgInS, AgInS₂, CulnS, CuInS₂, CuGaO₂, AgGaO₂, or AgAlO₂; or a combination thereof.

Examples of the Group IV-VI semiconductor compound may include: a binary compound, such as SnS, SnSe, SnTe, PbS, PbSe, PbTe, or the like; a ternary compound, such as SnSeS, SnSeTe, SnSTe, PbSeS, PbSeTe, PbSTe, SnPbS, SnPbSe, SnPbTe, or the like; a quaternary compound, such as SnPbSSe, SnPbSeTe, SnPbSTe, or the like; or a combination thereof.

The Group IV element or compound may include: a single element compound, such as Si or Ge; a binary compound, such as SiC or SiGe; or a combination thereof.

Each element included in a multi-element compound such as the binary compound, ternary compound and quaternary compound, may exist in a particle with a uniform concentration or non-uniform concentration.

In one or more embodiments, the quantum dot may have a single structure or a dual core-shell structure. In the case of the quantum dot having a single structure, the concentration of each element included in the corresponding quantum dot is uniform. In one or more embodiments, the material contained in the core and the material contained in the shell may be different from each other.

The shell of the quantum dot may act as a protective layer to prevent chemical degeneration of the core to maintain semiconductor characteristics and/or as a charging layer to impart electrophoretic characteristics to the quantum dot. The shell may be a single layer or a multi-layer. The element presented in the interface between the core and the shell of the quantum dot may have a concentration gradient that decreases toward the center of the quantum dot.

Examples of the shell of the quantum dot may be an oxide of metal, metalloid, or non-metal, a semiconductor compound, and a combination thereof. Examples of the oxide of a metal, a metalloid, or a non-metal may include at least one of a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO; a ternary compound, such as MgAl₂O₄, CoFe₂O₄, NiFe₂O₄, or CoMn₂O₄; or a combination thereof. Examples of the semiconductor compound may include, as described herein, a Group II-VI semiconductor compound, a Group III-V semiconductor compound, a Group III-VI semiconductor compound, a Group I-III-VI semiconductor compound, a Group IV-VI semiconductor compound, or a combination thereof. In addition, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or a combination thereof.

A full width at half maximum (FWHM) of an emission wavelength spectrum of the quantum dot may be about 45 nm or less, for example, about 40 nm or less, for example, about 30 nm or less, and within these ranges, color purity or color reproducibility may be increased. For example, the FWHM of an emission wavelength spectrum of the quantum dot may be about 10 nm to about 45 nm, or about 10 nm to about 40 nm, or about 10 nm to about 30 nm, or about 10 nm to about 25 nm. In addition, since the light emitted through the quantum dot is emitted in all directions, the wide viewing angle may be improved.

In addition, the quantum dot may be a spherical particle, a pyramidal particle, a multi-arm particle, a cubic nanoparticle, a nanotube particle, a nanowire particle, a nanofiber particle, or a nanoplate particle. Each quantum dot in a plurality of quantum dots may have the same or different morphology.

Since the energy band gap may be adjusted by controlling the size of the quantum dot, light having various wavelength bands may be obtained from the quantum dot emission layer. Therefore, by using quantum dots of different sizes, a light-emitting device that emits light of various wavelengths may be implemented. In one or more embodiments, the size of the quantum dot may be selected to emit red, green and/or blue light. In addition, the size of the quantum dot may be configured to emit white light by combining light of various colors.

### Electron transport area in interlayer 130

The electron transport area may have: i) a single-layer structure consisting of a single layer, wherein the single layer consists of a single material, ii) a single-layer structure consisting of a single layer, wherein the single layer consists of a plurality of different materials, or iii) a multi-layer structure including a plurality of layers, wherein each layer independently includes a single material or a plurality of materials.

The electron transport area may include a buffer layer, a hole blocking layer, an electron control layer, an electron transport layer, an electron injection layer, or a combination thereof.

For example, the electron transport area may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, the constituting layers of each structure being sequentially stacked from an emission layer.

In one or more embodiments, the electron transport area (for example, the buffer layer, the hole blocking layer, the electron control layer, or the electron transport layer in the electron transport area) may include a metal-free compound including at least one π electron-deficient nitrogen-containing C₁-C₆₀ (*e.g.* C₁-C₃₀) cyclic group.

In one or more embodiments, the electron transport area may include a compound represented by Formula 601 below:

Formula 601 [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₃-C₆₀ (*e.g.* C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ (e.g. C₃-C₃₀) carbocyclic group unsubstituted or substituted with at least one R₁₀ₐ, a C₁-C₆₀ (e.g. C₁-C₂₀) heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), - P(Q₆₀₁)(Q₆₀₂), or -P(=O)(Q₆₀₁)(Q₆₀₂),
Q₆₀₁ to Q₆₀₃ are respectively as described in connection with Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ (e.g. C₁-C₃₀) cyclic group unsubstituted or substituted with at least one R₁₀ₐ.

In one or more embodiments, when xe11 in Formula 601 is 2 or greater, two or more of Ar₆₀₁(s) may be linked via a single bond.

In one or more embodiments, Ar₆₀₁ in Formula 601 may be a substituted or unsubstituted anthracene group.

In one or more embodiments, the electron transport area may include a compound represented by Formula 601-1: 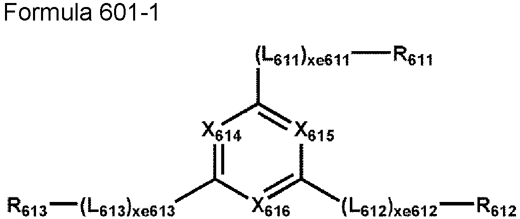 wherein, in Formula 601-1,
X₆₁₄ may be N or C(R₆₁₄), X₆₁₅ may be N or C(R₆₁₅), X₆₁₆ may be N or C(R₆₁₆), at least one of X₆₁₄ to X₆₁₆ may be N,
L₆₁₁ to L₆₁₃ are respectively as described in connection with L₆₀₁,
xe611 to xe613 are respectively as described in connection with xe1,
R₆₁₁ to R₆₁₃ are respectively as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ (*e.g.* C₁-C₁₀) alkyl group, a C₁-C₂₀ (*e.g.* C₁-C₁₀) alkoxy group, a C₁-C₂₀ (*e.g.* C₁-C₁₀) alkylthio group, a C₃-C₆₀ (*e.g.* C₃-C₃₀) carbocyclic group unsubstituted or substituted with at least one R₁₀ₐ, or a C₁-C₆₀ (*e.g.* C₁-C₂₀) heterocyclic group unsubstituted or substituted with at least one R₁₀ₐ.

In one or more embodiments, xe1 and xe611 to xe613 in Formulae 601 and 601-1 may each independently be 0, 1, or 2.

The electron transport area may include at least one of Compounds ET1 to ET47, 2,9-dimethyl-4,7-diphenyl-1,10-phenanthroline (BCP), 4,7-diphenyl-1,10-phenanthroline (Bphen), tris(8-hydroxyquinolinato)aluminium (Alq₃), bis(2-methyl-8-quinolinolato-N1,O8)-(1,1'-biphenyl-4-olato)aluminium (Balq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), diphenyl(4-(triphenylsilyl)phenyl)-phosphine oxide (TSPO1), or a combination thereof:

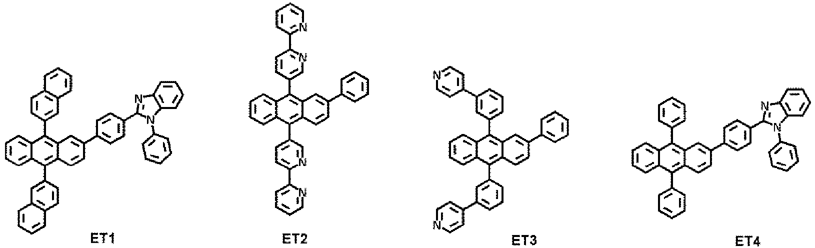

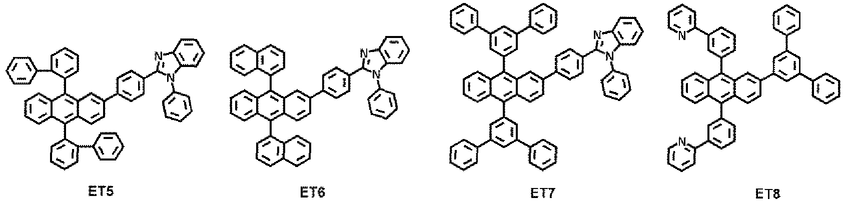

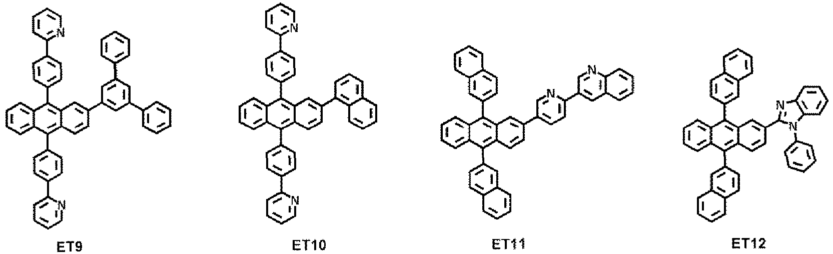

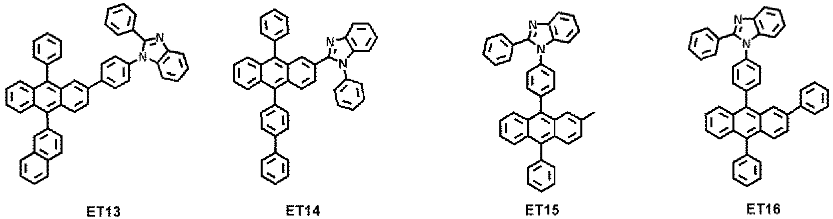

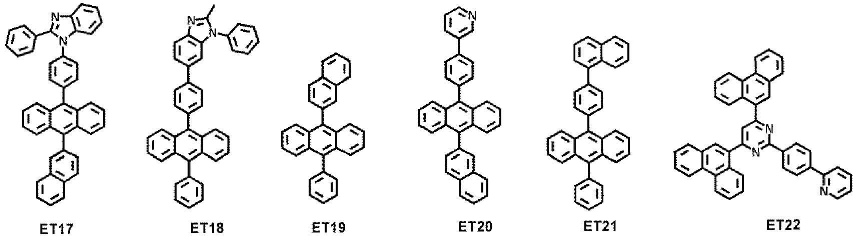

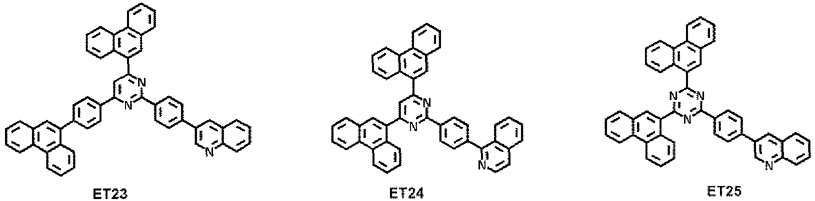

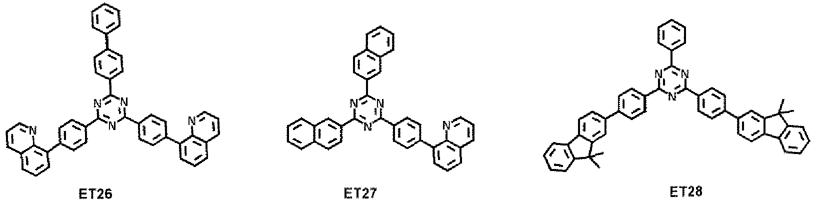

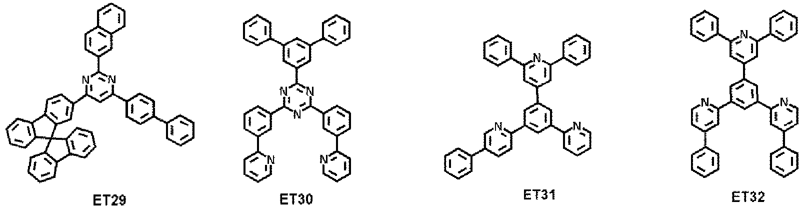

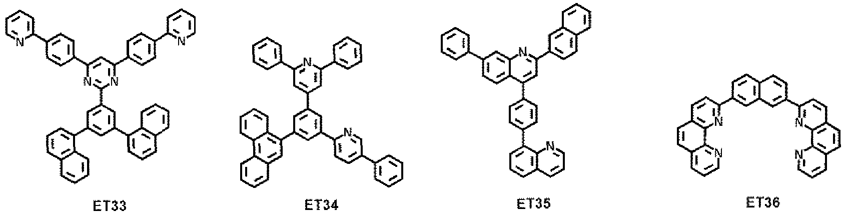

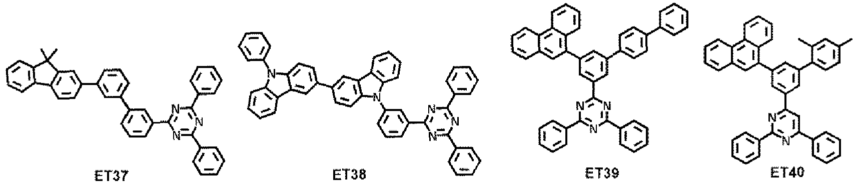

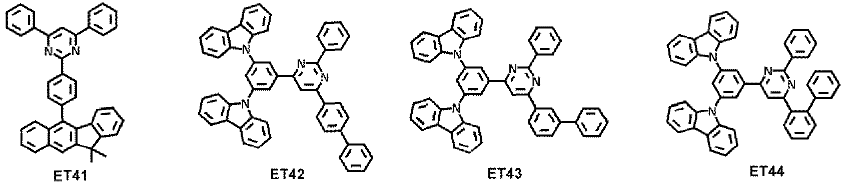

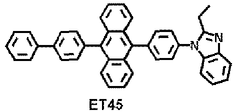

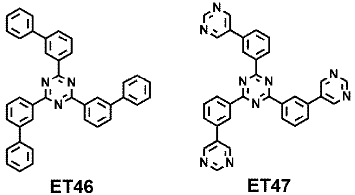

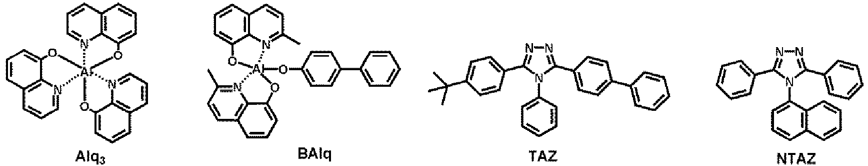

A thickness of the electron transport area may be from about 100 Å to about 5,000 Å, for example, about 160 Å to about 4,000 Å. When the electron transport area includes a buffer layer, a hole blocking layer, an electron control layer, an electron transport layer, or a combination thereof, the thickness of the buffer layer, the hole blocking layer, or the electron control layer may each independently be from about 20 Å to about 1,000 Å, for example, about 30 Å to about 300 Å, and the thickness of the electron transport layer may be from about 100 Å to about 1000 Å, for example, about 150 Å to about 500 Å. When the thickness of the buffer layer, the hole blocking layer, the electron control layer, the electron transport layer, and/or the electron transport layer are within these ranges, satisfactory electron transporting characteristics may be obtained without a substantial increase in driving voltage.

The electron transport area (for example, the electron transport layer in the electron transport area) may further include, in addition to the materials described above, a metal-containing material.

The metal-containing material may include an alkali metal complex, an alkaline earth metal complex, or a combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or a combination thereof.

In one or more embodiments, the metal-containing material may include a Li complex. The Li complex may include, for example, Compound ET-D1 (LiQ) or ET-D2:

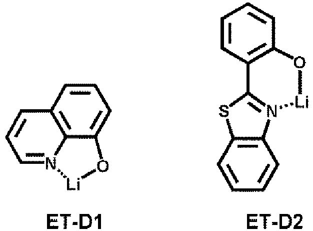

The electron transport area may include an electron injection layer that facilitates the injection of electrons from the second electrode 150. The electron injection layer may be in direct contact with the second electrode 150.

The electron injection layer may have: i) a single-layer structure consisting of a single layer, wherein the single layer consists of a single material, ii) a single-layer structure consisting of a single layer, wherein the single layer consists of a plurality of different materials, or iii) a multi-layer structure including a plurality of layers, wherein each layer independently includes a single material or a plurality of materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or a combination thereof.

The alkali metal may include Li, Na, K, Rb, Cs, or a combination thereof. The alkaline earth metal may include Mg, Ca, Sr, Ba, or a combination thereof. The rare earth metal may include Sc, Y, Ce, Tb, Yb, Gd, or a combination thereof.

The alkali metal-containing compound, the alkaline earth metal-containing compound, and the rare earth metal-containing compound may include oxides, halides (for example, fluorides, chlorides, bromides, or iodides), or tellurides of the alkali metal, the alkaline earth metal, and the rare earth metal, or a combination thereof.

The alkali metal-containing compound may include alkali metal oxides, such as Li₂O, Cs₂O, or K₂O, alkali metal halides, such as LiF, NaF, CsF, KF, Lil, Nal, Csl, or Kl, or a combination thereof. The alkaline earth metal-containing compound may include an alkaline earth metal compound, such as BaO, SrO, CaO, BaₓSr₁₋ₓO (wherein x is a real number satisfying the condition of 0<x<1), BaₓCa₁₋ₓO (wherein x is a real number satisfying the condition of 0<x<1), or the like. The rare earth metal-containing compound may include YbF₃, ScF₃, Sc₂O₃, Y₂O₃, Ce₂O₃, GdF₃, TbF₃, YbI₃, ScI₃, TbI₃, or a combination thereof. In one or more embodiments, the rare earth metal-containing compound may include lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may include i) one of ions of the alkali metal, the alkaline earth metal, and the rare earth metal and ii), as a ligand bonded to the metal ion, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or a combination thereof.

The electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or a combination thereof, as described above. In one or more embodiments, the electron injection layer may further include an organic material (for example, a compound represented by Formula 601).

In one or more embodiments, the electron injection layer may consist of i) an alkali metal-containing compound (for example, an alkali metal halide), ii) a) an alkali metal-containing compound (for example, an alkali metal halide); and b) an alkali metal, an alkaline earth metal, a rare earth metal, or a combination thereof. In one or more embodiments, the electron injection layer may be a Kl:Yb co-deposited layer, an Rbl:Yb co-deposited layer, or the like.

When the electron injection layer further includes an organic material, alkali metal, alkaline earth metal, rare earth metal, an alkali metal-containing compound, an alkaline earth metal-containing compound, a rare earth metal-containing compound, alkali metal complex, alkaline earth-metal complex, rare earth metal complex, or a combination thereof may be homogeneously or non-homogeneously dispersed in a matrix including the organic material.

A thickness of the electron injection layer may be in a range of about 1 Å to about 100 Å, and, for example, about 3 Å to about 90 Å. When the thickness of the electron injection layer is within the range described above, satisfactory electron injection characteristics may be obtained without a substantial increase in driving voltage.

### [Second electrode 150]

The second electrode 150 may be arranged on the interlayer 130 having such a structure. The second electrode 150 may be a cathode, which is an electron injection electrode, and as the material for the second electrode 150, a metal, an alloy, an electrically conductive compound, or a combination thereof, each having a low work function, may be used.

In one or more embodiments, the second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or a combination thereof. The second electrode 150 may be a transmissive electrode, a semi-transmissive electrode, or a reflective electrode.

The second electrode 150 may have a single-layer structure or a multi-layer structure including two or more layers.

### Capping Layer

A first capping layer may be arranged outside the first electrode 110, and/or a second capping layer may be arranged outside the second electrode 150. In one or more embodiments, the light-emitting device 10 may have a structure in which the first capping layer, the first electrode 110, the interlayer 130, and the second electrode 150 are sequentially stacked in this stated order, a structure in which the first electrode 110, the interlayer 130, the second electrode 150, and the second capping layer are sequentially stacked in this stated order, or a structure in which the first capping layer, the first electrode 110, the interlayer 130, the second electrode 150, and the second capping layer are sequentially stacked in this stated order.

Light generated in an emission layer of the interlayer 130 of the light-emitting device 10 may be extracted toward the outside through the first electrode 110, which is a semi-transmissive electrode or a transmissive electrode, and the first capping layer or light generated in an emission layer of the interlayer 130 of the light-emitting device 10 may be extracted toward the outside through the second electrode 150, which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the emission efficiency of the light-emitting device 10 may be improved.

Each of the first capping layer and second capping layer may include a material having a refractive index (at 589 nm) of 1.6 or greater.

The first capping layer and the second capping layer may each independently be an organic capping layer including an organic material, an inorganic capping layer including an inorganic material, or a composite capping layer including an organic material and an inorganic material.

At least one of the first capping layer and the second capping layer may each independently include carbocyclic compounds, heterocyclic compounds, amine group-containing compounds, porphyrin derivatives, phthalocyanine derivatives, naphthalocyanine derivatives, alkali metal complexes, alkaline earth metal complexes, or a combination thereof. The carbocyclic compound, the heterocyclic compound, and the amine group-containing compound may be optionally substituted with a substituent containing O, N, S, Se, Si, F, CI, Br, I, or a combination thereof.

In one or more embodiments, at least one of the first capping layer and the second capping layer may each independently include an amine group-containing compound.

In one or more embodiments, at least one of the first capping layer and the second capping layer may each independently include a compound represented by Formula 201, a compound represented by Formula 202, or a combination thereof.

In one or more embodiments, at least one of the first capping layer and the second capping layer may each independently include one of Compounds HT28 to HT33, one of Compounds CP1 to CP7, β-NPB, or a combination thereof:

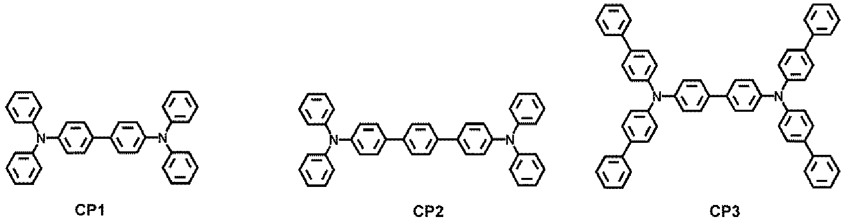

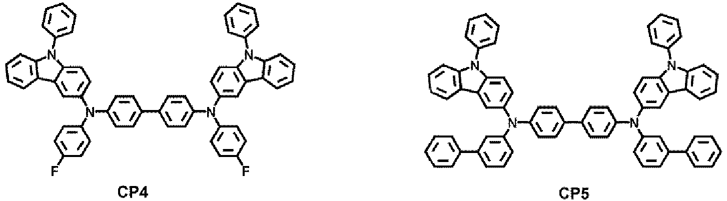

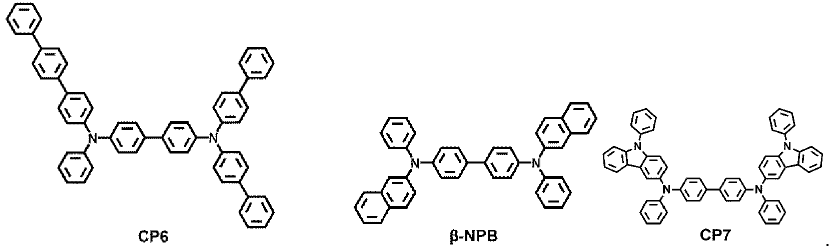

### Electronic Apparatus

The light-emitting device may be included in various electronic apparatuses. In one or more embodiments, an electronic apparatus including the light-emitting device may be a light-emitting apparatus, an authentication apparatus, or the like.

The electronic apparatus (for example, a display apparatus) may further include, in addition to the light-emitting device, i) a color filter, ii) a color conversion layer, or iii) a color filter and a color conversion layer. The color filter and/or the color conversion layer may be arranged in at least one traveling direction of light emitted from the light-emitting device. For example, the light emitted from the light-emitting device may be blue light or white light. The light-emitting device and the color conversion layer are respectively the same as those described above. In one or more embodiments, the color conversion layer may include a quantum dot or an organic material.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be arranged among the subpixel areas to define each of the subpixel areas.

The color filter may further include a plurality of color filter areas and light-shielding patterns arranged among the color filter areas, and the color conversion layer may include a plurality of color conversion areas and light-shielding patterns arranged among the color conversion areas.

The color filter areas (or the color conversion areas) may include a first area emitting first color light, a second area emitting second color light, and/or a third area emitting third color light, and the first color light, the second color light, and/or the third color light may have different maximum emission wavelengths from one another. In one or more embodiments, the first color light may be red light, the second color light may be green light, and the third color light may be blue light. In one or more embodiments, the color filter areas (or the color conversion areas) may include quantum dots. In detail, the first area may include a red quantum dot, the second area may include a green quantum dot, and the third area may not include a quantum dot. The quantum dot is the same as described in the present specification. The first area, the second area, and/or the third area may each further include a scatterer.

In one or more embodiments, the light-emitting device may emit a first light, the first area may absorb the first light to emit a first color light, the second area may absorb the first light to emit second color light, and the third area may absorb the first light to emit third color light. In this regard, the first color light, the second color light, and the third color light may have different maximum emission wavelengths. In detail, the first light may be blue light (for example, having a maximum emission wavelength of about 420 nm to about 460 nm), the first color light may be red light (for example, having a maximum emission wavelength of about 610 nm to about 640 nm, the second color light may be green light (for example, having a maximum emission wavelength of about 510 nm to about 550 nm), and the third color light may be blue light (for example, having a maximum emission wavelength of about 420 nm to about 460 nm).

The electronic apparatus may further include a thin-film transistor in addition to the light-emitting device as described above. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulating film, or the like.

The activation layer may include crystalline silicon, amorphous silicon, organic semiconductor, oxide semiconductor, or the like.

The electronic apparatus may further include a sealing portion for sealing the light-emitting device. The sealing portion and/or the color conversion layer may be arranged between the color filter and the light-emitting device. The sealing portion allows light from the light-emitting device to be extracted to the outside, while simultaneously preventing ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic apparatus may be flexible.

Various functional layers may be additionally arranged on the sealing portion, in addition to the color filter and/or the color conversion layer, according to the use of the electronic apparatus. The functional layers may include a touch screen layer, a polarizing layer, and the like. The touch screen layer may be a pressure-sensitive touch screen layer, a capacitive touch screen layer, or an infrared touch screen layer. The authentication apparatus may be, for example, a biometric authentication apparatus that authenticates an individual by using biometric information of a living body (for example, fingertips, pupils, or the like).

The authentication apparatus may further include, in addition to the light-emitting device, a biometric information collector.

The electronic apparatus may be applied to various displays, light sources, lighting, personal computers (for example, a mobile personal computer), mobile phones, digital cameras, electronic diaries, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, endoscope displays, or the like), fish finders, various measuring instruments, meters (for example, meters for a vehicle, an aircraft, a vessel, or the like), projectors, or the like.

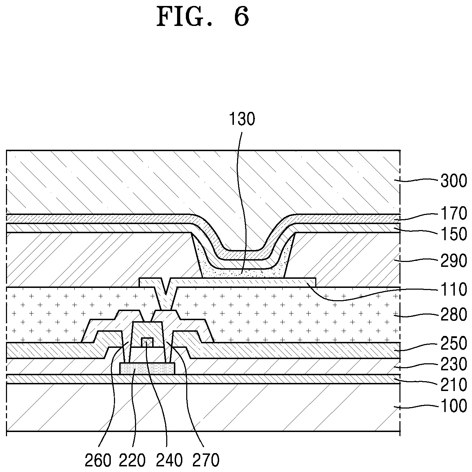

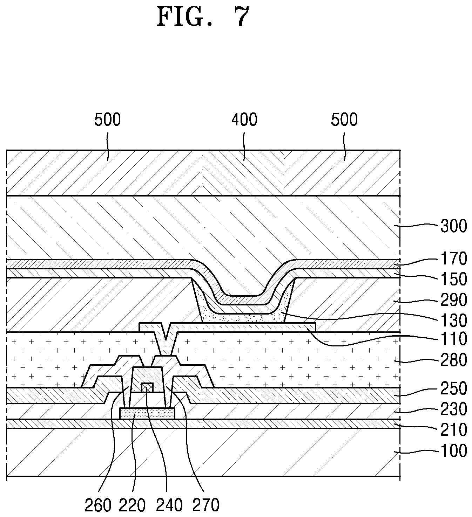

### Description of FIGS. 6 and 7

FIG. 6 depicts a cross-sectional view of a light-emitting apparatus according to one or more embodiments described herein and in further detail below.

The light-emitting apparatus of FIG. 6 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be formed on the substrate 100. The buffer layer 210 may prevent penetration of impurities through the substrate 100 and may provide a flat surface on the substrate 100.

A TFT may be arranged on the buffer layer 210. The TFT may include an activation layer 220, a gate electrode 240, a source electrode 260, and a drain electrode 270, but embodiments are not limited thereto.

The activation layer 220 may include an inorganic semiconductor such as silicon or polysilicon, an organic semiconductor, or an oxide semiconductor, and may include a source area, a drain area, and a channel area.

A gate insulating film 230 for insulating the activation layer 220 from the gate electrode 240 may be arranged on the activation layer 220, and the gate electrode 240 may be arranged on the gate insulating film 230.

An interlayer insulating film 250 is arranged on the gate electrode 240. The interlayer insulating film 250 may be placed between the gate electrode 240 and the source electrode 260 to insulate the gate electrode 240 from the source electrode 260 and between the gate electrode 240 and the drain electrode 270 to insulate the gate electrode 240 from the drain electrode 270.

The source electrode 260 and the drain electrode 270 may be arranged on the interlayer insulating film 250. The interlayer insulating film 250 and the gate insulating film 230 may be formed to expose the source area and the drain area of the activation layer 220, and the source electrode 260 and the drain electrode 270 may be in contact with the exposed portions of the source area and the drain area of the activation layer 220.

The TFT is electrically connected to a light-emitting device to drive the light-emitting device, and is covered by a passivation layer 280. The passivation layer 280 may include an inorganic insulating film, an organic insulating film, or a combination thereof. A light-emitting device is provided on the passivation layer 280. The light-emitting device may include a first electrode 110, a second electrode 150, and an interlayer 130 arranged between the first electrode 110 and the second electrode 150.

The first electrode 110 may be formed on the passivation layer 280. The passivation layer 280 does not completely cover the drain electrode 270 and exposes a portion of the drain electrode 270, and the first electrode 110 is connected to the exposed portion of the drain electrode 270.

A pixel-defining layer 290 containing an insulating material may be arranged on the first electrode 110. The pixel-defining layer 290 exposes an area of the first electrode 110, and an interlayer 130 may be formed in the exposed area of the first electrode 110. The pixel-defining layer 290 may be a polyimide or polyacrylic organic film. Although not shown in FIG. 6, at least some layers of the interlayer 130 may extend beyond the upper portion of the pixel-defining layer 290 to be arranged in the form of a common layer.

The second electrode 150 may be arranged on the interlayer 130, and a capping layer 170 may be additionally formed on the second electrode 150. The capping layer 170 may be formed to cover the second electrode 150.

The encapsulation portion 300 may be arranged on the capping layer 170. The encapsulation portion 300 may be arranged on a light-emitting device to protect the light-emitting device from moisture or oxygen. The encapsulation portion 300 may include: an inorganic film including silicon nitride (SiNx), silicon oxide (SiOx), indium tin oxide, indium zinc oxide, or a combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, or the like), an epoxy-based resin (for example, aliphatic glycidyl ether (AGE), or the like), or a combination thereof; or a combination of the inorganic film and the organic film.

FIG. 7 shows a cross-sectional view of a light-emitting apparatus according to one or more embodiments.

The light-emitting apparatus of FIG. 7 is the same as the light-emitting apparatus of FIG. 6, except that a light blocking pattern 500 and a functional area 400 are additionally arranged on the encapsulation portion 300. The functional area 400 may be a combination of i) a color filter area, ii) a color conversion area, or iii) a combination of the color filter area and the color conversion area. In one or more embodiments, the light-emitting device included in the light-emitting apparatus of FIG. 7 may be a tandem light-emitting device.

Respective layers included in the hole transport area, the emission layer, and the electron transport area may be formed in a certain area by using one or more suitable methods selected from vacuum deposition, spin coating, casting, Langmuir-Blodgett (L-B) deposition, ink-jet printing, laser-printing, laser-induced thermal imaging, or the like.

When layers constituting the hole transport area, an emission layer, and layers constituting the electron transport area are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed. However, the deposition conditions are not limited thereto.

When layers are formed using spin coating, the coating conditions may vary according to the compound that is used to form the layer and the desired structure and properties of the layer to be formed. For example, the spin rate may be in the range of about 2000 revolutions per minute (rpm) to about 5000 rpm, and a temperature at which heat treatment is performed to remove a solvent after coating may be in the range of about 80° C to about 200° C. However, the coating conditions are not limited thereto.

### Definition of Terms

The term "C₃-C₆₀ carbocyclic group" as used herein refers to a cyclic group consisting of carbon only and having three to sixty carbon atoms, and the term "C₁-C₆₀ heterocyclic group" as used herein refers to a cyclic group that has one to sixty carbon atoms and further has, in addition to carbon, a heteroatom. The C₃-C₆₀ carbocyclic group and the C₁-C₆₀ heterocyclic group may each be a monocyclic group consisting of one ring or a polycyclic group in which two or more rings are condensed with each other. For example, the number of ring-forming atoms of the C₁-C₆₀ heterocyclic group may be from 3 to 61.

The "cyclic group" as used herein may include the C₃-C₆₀ carbocyclic group and the C₁-C₆₀ heterocyclic group.

The term "π electron-rich C₃-C₆₀ cyclic group" as used herein refers to a cyclic group that has three to sixty carbon atoms and does not include *-N=*' as a ring-forming moiety, and the term "π electron-deficient nitrogen-containing C₁-C₆₀ cyclic group" as used herein refers to a heterocyclic group that has one to sixty carbon atoms and includes *-N=*' as a ring-forming moiety.

In one or more embodiments,
the C₃-C₆₀ carbocyclic group may be i) group T1 or ii) a condensed cyclic group in which two or more groups T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) group T2, ii) a condensed cyclic group in which two or more groups T2 are condensed with each other, or iii) a condensed cyclic group in which at least one group T2 and at least one group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) group T1, ii) a condensed cyclic group in which two or more groups T1 are condensed with each other, iii) group T3, iv) a condensed cyclic group in which two or more groups T3 are condensed with each other, or v) a condensed cyclic group in which at least one group T3 and at least one group T1 are condensed with each other (for example, the C₃-C₆₀ carbocyclic group, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ cyclic group may be i) group T4, ii) a condensed cyclic group in which two or more group T4 are condensed with each other, iii) a condensed cyclic group in which at least one group T4 and at least one group T1 are condensed with each other, iv) a condensed cyclic group in which at least one group T4 and at least one group T3 are condensed with each other, or v) a condensed cyclic group in which at least one group T4, at least one group T1, and at least one group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
the group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group,
the group T3 may be a furan group, a thiophene group, a 1H-pyrrole group, a silole group, or a borole group, and
the group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "cyclic group", "C₃-C₆₀ carbocyclic group", "C₁-C₆₀ heterocyclic group", "π electron-rich C₃-C₆₀ cyclic group", or "π electron-deficient nitrogen-containing C₁-C₆₀ cyclic group" as used herein refer to a group condensed to any cyclic group or a polyvalent group (for example, a divalent group, a trivalent group, a tetravalent group, etc.), depending on the structure of a formula in connection with which the terms are used. In one or more embodiments, "a benzene group" may be a benzo group, a phenyl group, a phenylene group, or the like, which may be easily understood by one of ordinary skill in the art according to the structure of a formula including the "benzene group."

Examples of the monovalent C₃-C₆₀ carbocyclic group and the monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group, and examples of the divalent C₃-C₆₀ carbocyclic group and the monovalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as used herein refers to a linear or branched aliphatic hydrocarbon monovalent group that has one to sixty carbon atoms, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tertoctyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein refers to a divalent group having the same structure as the C₁-C₆₀ alkyl group. Corresponding definitions apply to other ranges given for the number of carbon atoms in an alkyl/alkylene group.

The term "C₂-C₆₀ alkenyl group" as used herein refers to a monovalent hydrocarbon group having at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group. Corresponding definitions apply to other ranges given for the number of carbon atoms in an alkenyl/alkenylene group.

The term "C₂-C₆₀ alkynyl group" as used herein refers to a monovalent hydrocarbon group having at least one carbon-carbon triple bond in the middle or at the terminus of the C₂-C₆₀ alkyl group, and examples thereof include an ethynyl group and a propynyl group. The term "C₂-C₆₀ alkynylene group" as used herein refers to a divalent group having the same structure as the C₂-C₆₀ alkynyl group. Corresponding definitions apply to other ranges given for the number of carbon atoms in an alkynyl/alkynylene group.

The term "C₁-C₆₀ alkoxy group" as used herein refers to a monovalent group represented by -OA₁₀₁ (wherein A₁₀₁ is the C₁-C₆₀ alkyl group), and examples thereof include a methoxy group, an ethoxy group, and an isopropyloxy group. The term "C₁-C₆₀ alkylthio group" as used herein refers to a monovalent group represented by -SA₁₀₂ (wherein A₁₀₂ is the C₁-C₆₀ alkyl group). Corresponding definitions apply to other ranges given for the number of carbon atoms in an alkoxy group.

The term "C₃-C₁₀ cycloalkyl group" as used herein refers to a monovalent saturated hydrocarbon cyclic group having 3 to 10 carbon atoms, and examples thereof include a cyclopropyl group, a cyclobutyl group, a cyclopentyl group, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent cyclic group that further includes, in addition to a carbon atom, at least one heteroatom as a ring-forming atom and has 1 to 10 carbon atoms, and examples thereof include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" used herein refers to a monovalent cyclic group that has three to ten carbon atoms and at least one carbon-carbon double bond in the ring thereof and no aromaticity, and examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group that has, in addition to a carbon atom, at least one heteroatom as a ring-forming atom, 1 to 10 carbon atoms, and at least one carbon-carbon double bond in the cyclic structure thereof. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having six to sixty carbon atoms, and the term "C₆-C₆₀ arylene group" as used herein refers to a divalent group having a carbocyclic aromatic system having six to sixty carbon atoms. Examples of the C₆-C₆₀ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the rings may be condensed with each other. Corresponding definitions apply to other ranges given for the number of carbon atoms in an aryl/arylene group.

The term "C₁-C₆₀ heteroaryl group" as used herein refers to a monovalent group having a heterocyclic aromatic system that has, in addition to a carbon atom, at least one heteroatom (e.g., N, O, P, S, Si, Se, Ge, or B) as a ring-forming atom, and 1 to 60 carbon atoms. The term "C₁-C₆₀ heteroarylene group" as used herein refers to a divalent group having a heterocyclic aromatic system that has, in addition to a carbon atom, at least one heteroatom (e.g., N, O, P, S, Si, Se, Ge, or B) as a ring-forming atom, and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed with each other. Corresponding definitions apply to other ranges given for the number of carbon atoms in an heteroaryl/heteroarylene group.

The term "monovalent non-aromatic condensed polycyclic group" as used herein refers to a monovalent group having two or more rings condensed to each other, only carbon atoms (for example, having 8 to 60 carbon atoms) as ring-forming atoms, and no aromaticity in its molecular structure when considered as a whole. Examples of the monovalent non-aromatic condensed polycyclic group include an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group having two or more rings condensed to each other, at least one heteroatom (e.g., N, O, P, S, Si, Se, Ge, or B) other than carbon atoms (for example, having 1 to 60 carbon atoms), as a ring-forming atom, and no aromaticity in its molecular structure when considered as a whole. Examples of the monovalent non-aromatic condensed heteropolycyclic group include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as used herein refers to a divalent group having the same structure as a monovalent non-aromatic condensed heteropolycyclic group.

The term "C₆-C₆₀ aryloxy group" as used herein indicates -OA₁₀₂ (wherein A₁₀₂ is the C₆-C₆₀ aryl group), and the term "C₆-C₆₀ arylthio group" as used herein indicates - SA₁₀₃ (wherein A₁₀₃ is the C₆-C₆₀ aryl group). Corresponding definitions apply to other ranges given for the number of carbon atoms in an aryloxy group and an arylthio group.

The term "C₁-C₆₀ heteroaryloxy group" as used herein indicates -SA₁₀₄ (wherein A₁₀₄ is the C₁-C₆₀ heteroaryl group), and the term "C₁-C₆₀ heteroarylthio group" as used herein indicates -SA₁₀₅ (wherein A₁₀₅ is the C₁-C₆₀ heteroaryl group).

R₁₀ₐ may be:
deuterium, -F, -Cl, -Br, -I, a hydroxyl group, a cyano group, or a nitro group;
a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, or a C₁-C₆₀ (*e.g.* C₁-C₂₀) alkoxy group, each unsubstituted or substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₁-C₆₀ (*e.g.* C₁-C₂₀) heteroaryloxy group, a C₆-C₆₀ (*e.g.* C₆-C₃₀) arylthio group, a C₁-C₆₀ (e.g. C₁-C₂₀) heteroarylthio group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), -P(Q₁₁)(Q₁₂), -P(=O)(Q₁₁)(Q₁₂), or a combination thereof;
a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₁-C₆₀ (*e.g.* C₁-C₂₀) heteroaryloxy group, a C₆-C₆₀ (*e.g.* C₆-C₃₀) arylthio group, or a C₁-C₆₀ (*e.g.* C₁-C₂₀) heteroarylthio group, each unsubstituted or substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₁-C₆₀ (*e.g.* C₁-C₂₀) alkylthio group, a C₃-C₆₀ (*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₁-C₆₀ (*e.g.* C₁-C₂₀) heteroaryloxy group, a C₆-C₆₀ (*e.g.* C₆-C₃₀) arylthio group, a C₁-C₆₀ (*e.g.* C₁-C₂₀) heteroarylthio group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(Q₂₁)(Q₂₂), -P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), - P(Q₃₁)(Q₃₂), or -P(=O)(Q₃₁)(Q₃₂).

Q₁ to Q₃, Q₁₁ to Q₁₃, Q₂₁ to Q₂₃ and Q₃₁ to Q₃₃ used herein may each independently be: hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (e.g. C₁-C₂₀) alkyl group, a C₂-C₆₀ (e.g. C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₁-C₆₀ (*e.g.* C₁-C₂₀) alkylthio group, or a C₃-C₆₀ (*e.g.* C₃-C₃₀) carbocyclic group, or a C₁-C₆₀ (*e.g.* C₁-C₂₀) heterocyclic group, each unsubstituted or substituted with at least one of deuterium, -F, a cyano group, a C₁-C₆₀ (*e.g.* C₁-C₂₀) alkyl group, a C₁-C₆₀ (*e.g.* C₁-C₂₀) alkoxy group, a C₁-C₆₀ (*e.g.* C₁-C₂₀) alkylthio group, a phenyl group, a biphenyl group, or a combination thereof.

The term "hetero atom" as used herein refers to an atom other than a carbon atom. Examples of the heteroatom include O, S, N, P, Si, B, Ge, Se, or a combination thereof.

The term "Ph" as used herein refers to a phenyl group, the term "Me" as used herein refers to a methyl group, the term "Et" as used herein refers to an ethyl group, the term "ter-Bu" or "Bu^{t}" as used herein refers to a tert-butyl group, and the term "OMe" as used herein refers to a methoxy group.

The term "biphenyl group" as used herein refers to "a phenyl group substituted with a phenyl group." In other words, the "biphenyl group" is a substituted phenyl group having a C₆-C₆₀ aryl group as a substituent.

The term "terphenyl group" as used herein refers to "a phenyl group substituted with a biphenyl group". The "terphenyl group" is a substituted phenyl group having, as a substituent, a C₆-C₆₀ aryl group substituted with a C₆-C₆₀ aryl group.
* and *' as used herein, unless defined otherwise, each refer to a binding site to a neighboring atom in a corresponding formula.

Hereinafter, a display apparatus according to one or more embodiments will be described in more detail with reference to Examples.

### Examples

### Example 1

### Manufacture of light-emitting device

As a substrate and an anode, a first glass substrate with Corning 15 ohms per square centimeter (Ω/cm²) (having a thickness of 100 Å) ITO formed thereon, a second glass substrate with (having a thickness of 1,000 Å) Ag formed thereon, and a third glass with Corning 15 Ω/cm² (having a thickness of 100 Å) ITO formed thereon were each cut to a size of 50 millimeters (mm) x 50 mm x 0.7 mm, sonicated with isopropyl alcohol and deionized (DI) water each for 5 minutes, cleaned by irradiation of ultraviolet light and exposure of ozone thereto for 30 minutes. Then, the first glass substrate, the second glass substrate, and the third glass substrate were sequentially stacked on a vacuum deposition apparatus in the stated order.

HAT-CN was deposited on the anode to form a hole injection layer having a thickness of 50 Å.

NPB (having a thickness of 250 Å) and TCTA (having a thickness of 50 Å) were sequentially deposited on the hole injection layer to form a hole transport layer.

H125 and DF10 (an amount of DF10 was 1 wt%) were co-deposited on the hole transport layer to form a first emission layer having a thickness of 200 Å, ET46 (having a thickness of 50 Å) was deposited thereon to form a first buffer layer, and ET47 and LiQ were co-deposited on the first buffer layer at a weight ratio of 5:5 to form a first electron transport layer having a thickness of 250 Å, thereby forming a first emitting unit.

BCP and Li (an amount of Li was 1 wt%) were co-deposited on the first emitting unit to form an n-type charge generation layer having a thickness of 50 Å, and HAT-CN was deposited thereon to form a p-type charge generation layer having a thickness of 50 Å, thereby forming a charge generation layer.

TCTA (having a thickness of 50 Å) was deposited on the charge generation layer to form a hole transport (HT)-auxiliary layer, H125 and DF10 (an amount of DF10 was 3 wt%) were co-deposited thereon to form a second emission layer having a thickness of 200 Å, ET46 (having a thickness of 50 Å) was deposited thereon to form a second buffer layer, and ET47 and LiQ were co-deposited on the second buffer layer at a weight ratio of 5:5 to form a second electron transport layer, thereby forming a second emitting unit.

Yb (10 Å) was deposited on the second emitting unit to form an electron injection layer, thereby forming an electron transport area.

Ag and Mg (having a thickness of 100 Å) were co-deposited on the electron transport area at a weight ratio of 9:1 to form a cathode, and CP7 (having a thickness of 600 Å) was deposited on the cathode, thereby manufacturing a light-emitting device.

### Manufacture of color conversion area

On the light-emitting device, a red color conversion area was formed on a position corresponding to a red subpixel area of the light-emitting device, a green color conversion area was formed on a position corresponding to a green subpixel area of the light-emitting device, and a blue color conversion area was formed on a position corresponding to a blue subpixel area of the light-emitting device, thereby manufacturing a display apparatus. QD has an InP/GaP/ZnS structure, and during QD synthesis, GQD and RQD were prepared by adjusting a composition ratio of Ga with GaCl₃. The red color conversion area, the green color conversion area, and the blue color conversion area were formed by an ink composition as follows:
Red color conversion area: PGMEA (50 wt%) + RQD (40 wt%) + TiO₂ (10 wt%).
Green color conversion area: PGMEA (40 wt%) + GQD (50 wt%) + TiO₂ (10 wt%).
Blue color conversion area: PGMEA (80 wt%) + TiO₂ (10 wt%) + FD37 (10 wt%).

### Comparative Example 1

A display apparatus was manufactured in the same manner as in Example 1, except that a blue color conversion area was formed by a composition as follows:

Blue color conversion area: PGMEA (90 wt%) + TiO₂ (10 wt%).

### Example 2

A display apparatus was manufactured in the same manner as in Example 1, except that, when the first emission layer and the second emission layer were formed, DF11 was used instead of DF10, respectively, and a blue color conversion area was formed by a composition as follows:

Blue color conversion area: PGMEA (80 wt%) + TiO₂ (10 wt%) + DF10 (10 wt%).

### Example 3

A display apparatus was manufactured in the same manner as in Example 2, except that a blue color conversion area was formed by a composition as follows:

Blue color conversion area: PGMEA (80 wt%) + TiO₂ (10 wt%) + FD37 (10 wt%).

### Comparative Example 2

A display apparatus was manufactured in the same manner as in Example 2, except that a blue color conversion area was formed by a composition as follows:

Blue color conversion area: PGMEA (90 wt%) + TiO₂ (10 wt%).

### Evaluation Example 1: Evaluation on efficiency of display apparatus

For each of Examples 1 to 3 and Comparative Examples 1 and 2, RGB efficiency (Eff, cd/R), white efficiency (W_Eff), and color matching rate (DCI, %) were obtained by measuring CIEx and CIEy color coordinates of red (R_x, R_y, Eff), green (G_x, G_y, Eff), and blue (B_x, B_y, Eff), using an IVL measuring apparatus and calculating the BT2020 of White, and the results thereof are shown in Table 1 below.

**Table 1**

| | | | RED | | | GREEN | | | BLUE | | | WHITE | | | |
|---|---|---|---|---|---|---|---|---|---|---|---|---|---|---|---|
| | Emission layer in light-emitting device | Emitter in blue color conversion area | R_x | R_y | Eff | G_x | G_y | Eff | B_x | B_y | Eff | W_Eff | | BT2020 | DCI |
| Example 1 | DF10 (460nm) | FD37 (465nm) | 0.702 | 0.295 | 6.1 | 0.230 | 0.730 | 21.1 | 0.145 | 0.047 | 2.3 | 9.6 | 98% | 89.9% | 99.8% |
| Comparative Example 1 | DF10 (460nm) | X | 0.702 | 0.295 | 6.1 | 0.230 | 0.730 | 21.1 | 0.149 | 0.041 | 2.1 | 9.8 | 100% | 89.1% | 99.7% |
| Example 2 | DF11 (455nm) | DF10 (460nm) | 0.702 | 0.295 | 6.5 | 0.230 | 0.730 | 23.8 | 0.149 | 0.041 | 2.0 | 10.2 | 104% | 89.1% | 99.7% |
| Example 3 | DF11 (455nm) | FD37 (465nm) | 0.702 | 0.295 | 6.5 | 0.230 | 0.730 | 23.8 | 0.145 | 0.047 | 2.4 | 10.3 | 105% | 89.9% | 99.8% |
| Comparative Example 2 | DF11 (455nm) | X | 0.702 | 0.295 | 6.5 | 0.230 | 0.730 | 23.8 | 0.152 | 0.037 | 1.8 | 10.3 | 105% | 88.3% | 99.4% |

**Table 2**

| | | | RED | | | GREEN | | | BLUE | | | WHITE | | | |
|---|---|---|---|---|---|---|---|---|---|---|---|---|---|---|---|
| | Emission layer in light-emitting device | Emitter in blue color conversion area | R_x | R_y | Eff | G_x | G_y | Eff | B_x | B_y | Eff | W_Eff | | BT2020 | DCI |
| Example 4 | DF11 (455nm) | InGaN (460nm) | 0.702 | 0.295 | 6.5 | 0.230 | 0.730 | 23.8 | 0.149 | 0.041 | 1.9 | 10.0 | 102% | 89.1% | 99.7% |
| Comparative Example 1 | DF10 (460nm) | X | 0.702 | 0.295 | 6.1 | 0.230 | 0.730 | 21.1 | 0.149 | 0.041 | 2.1 | 9.8 | 100% | 89.1% | 99.7% |
| Comparative Example 2 | DF11 (455nm) | X | 0.702 | 0.295 | 6.5 | 0.230 | 0.730 | 23.8 | 0.152 | 0.037 | 1.8 | 10.3 | 105% | 88.3% | 99.4% |

Referring to Table 1 above, when comparing Example 1 with Comparative Example 1 and Examples 2 and 3 with Comparative Example 2, in which the light-emitting device were each manufactured under the same condition, it may be confirmed that the color matching rate (BT2020) is significantly improved when an emitter having a longer wavelength than that of a dopant included in the light-emitting device is applied to a blue color conversion area.

Also, when comparing Example 2 with Example 3, in Example 2 where a dopant having a shorter wavelength is applied as a dopant included in the light-emitting device, compared to Example 3, it may be confirmed that efficiencies of the red and green increase due to an increase in quantum dot absorption.

### Example 4 (not forming part of the claimed invention)

A display apparatus was manufactured in the same manner as in Example 2, except that a blue color conversion area was formed by a composition as follows:
Blue color conversion area: PGMEA (40 wt%) + InGaN (an amount of In was 8 wt%) (50 wt%) + TiO₂ (10 wt%)

### Evaluation Example 2: Evaluation on efficiency of display apparatus

For each of Example 4 and Comparative Examples 1 and 2, RGB efficiency (Eff, cd/R), white efficiency (W_Eff), and color matching rate (DCI, %) were obtained by measuring CIEx and CIEy color coordinates of red (R_x, R_y, Eff), green (G_x, G_y, Eff), and blue (B_x, B_y, Eff) using an IVL measuring apparatus and calculating the BT2020 of White, and the results thereof are shown in Table 2 above.

Referring to Table 2, when comparing Example 4 with Comparative Example 2, it may be confirmed that the color matching rate (BT2020) is significantly improved when an emitter having a longer wavelength than that of a dopant included in the light-emitting device is applied to a blue color conversion area.

Also, when comparing Example 4 with Comparative Example 1, in Example 4 where a dopant having a shorter wavelength is applied as a dopant included in the light-emitting device, compared to Comparative Example 1, it may be confirmed that efficiencies of the red and green increase due to an increase in quantum dot absorption.

According to one or more embodiments as described in further detail above, a display apparatus with improved blue luminance, white luminescence efficiency, and color matching rate may be provided. The scope of the present disclosure is not limited by such effects.

It should be understood that the embodiments described herein should be considered in a descriptive sense and not for purposes of limitation. Descriptions of features or aspects within embodiments should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus, comprising:
a substrate (100);
a light-emitting device layer arranged on the substrate (100), wherein the light-emitting device layer comprises a first area (P1), a second area (P2), and a third area (P3), and wherein the light-emitting device layer further comprises at least one light-emitting device (10) emitting a first light; and
a color conversion layer arranged on the light-emitting device layer, wherein the color conversion layer comprises a first color conversion area (410a), a second color conversion area (410b), and a third color conversion area (410c),
wherein the first color conversion area (410a) is arranged to correspond to the first area (P1) of the light-emitting device layer, and emits a first color light,
the second color conversion area (410b) is arranged to correspond to the second area (P2) of the light-emitting device layer, and emits a second color light,
the third color conversion area (410c) is arranged to correspond to the third area (P3) of the light-emitting device layer, and emits a third color light,
a maximum emission wavelength of the first color light, a maximum emission wavelength of the second color light, and a maximum emission wavelength of the third color light are each greater than a maximum emission wavelength of the first light,
a color of the third color light is identical to that of the first light, and
the maximum emission wavelength of the third color light is greater than the maximum emission wavelength of the first light,
wherein the first color conversion area (410a) comprises a first emitter (411a), the second color conversion area (410b) comprises a second emitter (411b), and the third color conversion area (410c) comprises a third emitter (411c), and
the first emitter (411a) and the second emitter (411b) each independently comprise a phosphorescent dopant, a fluorescent dopant, a delayed fluorescence material, a quantum dot, or a combination thereof, **characterized in that**
the third emitter (411c) comprises a phosphorescent dopant, a fluorescent dopant, a delayed fluorescence material, or a combination thereof.

2. The display apparatus of claim 1, wherein the maximum emission wavelength of the third color light is 5 nanometers or more greater than the maximum emission wavelength of the first light.

3. The display apparatus of claim 1 or claim 2, wherein the first emitter (411a), the second emitter (411b), and the third emitter (411c) are different from one another.

4. The display apparatus of any one of claims 1 to 3, wherein the first emitter (411a) is arranged in a first path of the first light emitted from a portion corresponding to the first area (P1) of the light-emitting device layer,
the second emitter (411b) is arranged in a second path of the first light emitted from a portion corresponding to the second area (P2) of the light-emitting device layer, and
the third emitter (411c) is arranged in a third path of the first light emitted from a portion corresponding to the third area (P3) of the light-emitting device layer.

5. The display apparatus of any one of claims 1 to 4, wherein:
(i) the third color conversion area (410c) comprises the third emitter (411c) in an amount of 1 weight percent to 50 weight based on a total weight of the third color conversion area (410c); and/or
(ii) the maximum emission wavelength of the third emitter (411c) is 425 nanometers to 465 nanometers wherein the maximum emission wavelength is measured by using a quantum yield spectrometer to determine the emission wavelength of a single film of the third emitter (411c).

6. The display apparatus of any one of claims 1 to 5, wherein the phosphorescent dopant comprises an organometallic compound represented by Formula 401:
Formula 401 M(L₄₀₁)_{xc1}(L₄₀₂)_{xc2}
wherein L₄₀₁ is a ligand represented by Formula 402: 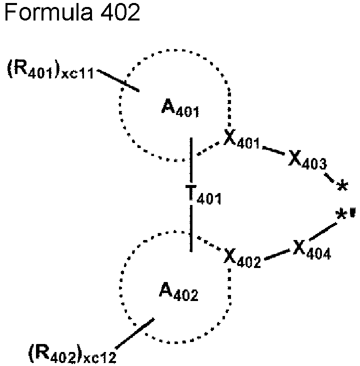 wherein, in Formulae 401 and 402,
M is a transition metal,
xc1 is 1, 2, or 3, wherein, when xc1 is 2 or3, two or more of L₄₀₁(s) are identical to or different from each other,
L₄₀₂ is an organic ligand, and xc2 is 0, 1, 2, 3, or 4, wherein, when xc2 is 2, 3, or 4, two or more of L₄₀₂(s) are identical to or different from each other,
X₄₀₁ and X₄₀₂ are each independently nitrogen or carbon,
ring A₄₀₁ and ring A₄₀₂ are each independently a C₃-C₆₀ carbocyclic group or a C₁-C₆₀ heterocyclic group,
T₄₀₁ is a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C=*', or *=C=*',
X₄₀₃ and X₄₀₄ are each independently a chemical bond, O, S, N(Q₄₁₃), B(Q₄₁₃), P(Q₄₁₃), C(Q₄₁₃)(Q₄₁₄), or Si(Q₄₁₃)(Q₄₁₄),
R₄₀₁ and R₄₀₂ are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group unsubstituted or substituted with at least one R₁₀ₐ, a C₁-C₂₀ alkoxy group unsubstituted or substituted with at least one R₁₀ₐ, a C₁-C₂₀ alkylthio group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), - P(Q₄₀₁)(Q₄₀₂), or -P(=O)(Q₄₀₁)(Q₄₀₂),
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each unsubstituted or substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₆₀ carbocyclic group, a C₁-C₆₀ heterocyclic group, a C₆-C₆₀ aryloxy group, a C₁-C₆₀ heteroaryloxy group, a C₆-C₆₀ arylthio group, a C₁-C₆₀ heteroarylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(Q₁₁)(Q₁₂), -P(=O)(Q₁₁)(Q₁₂), or a combination thereof;
a C₃-C₆₀ carbocyclic group, a C₁-C₆₀ heterocyclic group, a C₆-C₆₀ aryloxy group, a C₁-C₆₀ heteroaryloxy group, a C₆-C₆₀ arylthio group, a C₁-C₆₀ heteroarylthio group, a C₇-C₆₀ aryl alkyl group, or a C₂-C₆₀ heteroaryl alkyl group, each unsubstituted or substituted with at least one of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₆₀ carbocyclic group, a C₁-C₆₀ heterocyclic group, a C₆-C₆₀ aryloxy group, a C₁-C₆₀ heteroaryloxy group, a C₆-C₆₀ arylthio group, a C₁-C₆₀ heteroarylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(Q₂₁)(Q₂₂), -P(=O)(Q₂₁)(Q₂₂), or a combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), - P(Q₃₁)(Q₃₂), or -P(=O)(Q₃₁)(Q₃₂),
Q₁₁ to Q₁₃, Q₂₁ to Q₂₃, Q₃₁ to Q₃₃, and Q₄₁₁ to Q₄₁₄ are each independently: hydrogen, deuterium; -F; -Cl; -Br; -I; a hydroxyl group; a cyano group; a nitro group; an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group; a C₂-C₆₀ alkenyl group; a C₂-C₆₀ alkynyl group; a C₁-C₆₀ alkoxy group; a C₁-C₆₀ alkylthio group; a C₃-C₆₀ carbocyclic group, or a C₁-C₆₀ heterocyclic group, each unsubstituted or substituted with at least one of deuterium, -F, a cyano group, a C₁-C₆₀ alkyl group, a C₁-C₆₀ alkoxy group, a C₁-C₆₀ alkylthio group, a phenyl group, a biphenyl group, or a combination thereof,
xc11 and xc12 are each independently an integer from 0 to 10, and
* and *' in Formula 402 each indicate a binding site to M in Formula 401.

7. The display apparatus of any one of claims 1 to 6, wherein the fluorescent dopant comprises a compound represented by Formula 501: 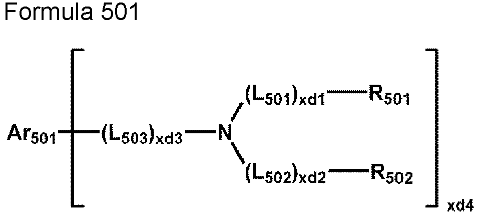 wherein, in Formula 501,
Ar₅₀₁, L₅₀₁ to L₅₀₃, R₅₀₁, and R₅₀₂ are each independently a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 are each independently 0, 1, 2, or 3,
xd4 is 1, 2, 3, 4, 5, or 6, and
R₁₀ₐ is as described in claim 6.

8. The display apparatus of any one of claims 1 to 7, wherein:
(i) the delayed fluorescence material comprises i) a material comprising at least one electron donor and at least one electron acceptor, ii) a material comprising a C₈-C₆₀ polycyclic group wherein two or more cyclic groups are condensed while sharing a boron atom (B), or a combination thereof; and/or
(ii) the quantum dot comprises a Group II-VI semiconductor compound, a Group III-V semiconductor compound, a Group III-VI semiconductor compound, a Group I-III-VI semiconductor compound, a Group IV-VI semiconductor compound, a Group IV element or compound, or a combination thereof.

9. The display apparatus of any one of claims 1 to 8, wherein at least one of the first color conversion area (410a), the second color conversion area (410b), and the third color conversion area (410c) further comprises a scatterer (412a, 412b, 412c), optionally wherein the scatterer (412a, 412b, 412c) comprises BiFeO₃, Fe₂O₃, WO₃, TiO₂, SiC, BaTiO₃, ZnO, ZrO₂, ZrO, Ta₂O₅, MoO₃, TeO₂, Nb₂O₅, Fe₃O₄, V₂O₅, Cu₂O, BP, Al₂O₃, In₂O₃, SnO₂, Sb₂O₃, ITO, or a combination thereof.

10. The display apparatus of any one of claims 1 to 9, wherein each light-emitting device of the at least one light-emitting device (10) comprises:
a first electrode (110);
a second electrode (150) facing the first electrode (110); and
an interlayer (130) arranged between the first electrode (110) and the second electrode (150), wherein the interlayer (130) comprises at least one emission layer.

11. The display apparatus of claim 10, wherein each emission layer of the at least one emission layer independently comprises a phosphorescent dopant, a fluorescent dopant, a delayed fluorescence material, a quantum dot, or a combination thereof.

12. The display apparatus of claim 10 or claim 11, wherein the at least one light-emitting device (10) is a tandem light-emitting device comprising: at least two emission zones sequentially stacked between the first electrode (110) and the second electrode (150); and a charge generation layer (133) arranged between the at least two emission zones, optionally wherein the at least two emission zones included in the tandem light-emitting device emit light having maximum emission wavelengths that are identical to or different from each other.

13. The display apparatus of any one of claims 1 to 12, wherein the maximum emission wavelength of the first light is 420 nanometers to 460 nanometers, wherein the maximum emission wavelength is measured by using a quantum yield spectrometer to determine the emission wavelength a single film of an emission layer of the light-emitting device.

14. The display apparatus of any one of claims 1 to 13, further comprising at least one color filter (420a, 420b, 420c) arranged on the color conversion layer to correspond to at least one of the first color conversion area (410a), the second color conversion area (410b), the third color conversion areas (410c), or a combination thereof.

## Patentansprüche

1. Anzeigeeinrichtung, umfassend:
ein Substrat (100);
eine auf dem Substrat (100) angeordnete Leuchtdiodenvorrichtungsschicht, wobei die Leuchtdiodenvorrichtungsschicht einen ersten Bereich (P1), einen zweiten Bereich (P2) und einen dritten Bereich (P3) umfasst und wobei die Leuchtdiodenvorrichtungsschicht weiter mindestens eine Leuchtdiodenvorrichtung (10) umfasst, die ein erstes Licht emittiert; und
eine auf der Leuchtdiodenvorrichtungsschicht angeordnete Farbumwandlungsschicht, wobei die Farbumwandlungsschicht einen ersten Farbumwandlungsbereich (410a), einen zweiten Farbumwandlungsbereich (410b) und einen dritten Farbumwandlungsbereich (410c) umfasst,
wobei der erste Farbumwandlungsbereich (410a) so angeordnet ist, dass er dem ersten Bereich (P1) der Leuchtdiodenvorrichtungsschicht entspricht und ein erstes Farblicht ausstrahlt,
der zweite Farbumwandlungsbereich (410b) so angeordnet ist, dass er dem zweiten Bereich (P2) der Leuchtdiodenvorrichtungsschicht entspricht und ein zweites Farblicht ausstrahlt,
der dritte Farbumwandlungsbereich (410c) so angeordnet ist, dass er dem dritten Bereich (P3) der Leuchtdiodenvorrichtungsschicht entspricht und drittes Farblicht ausstrahlt,
eine maximale Emissionswellenlänge des ersten Farblichts, eine maximale Emissionswellenlänge des zweiten Farblichts und eine maximale Emissionswellenlänge des dritten Farblichts jeweils größer sind als eine maximale Emissionswellenlänge des ersten Farblichts, und
eine Farbe des dritten Farblichts identisch ist mit derjenigen des ersten Lichts, und
die maximale Emissionswellenlänge des dritten Farblichts größer ist als die maximale Emissionswellenlänge des ersten Lichts,
wobei der erste Farbumwandlungsbereich (410a) einen ersten Emitter (411a) umfasst, der zweite Farbumwandlungsbereich (410b) einen zweiten Emitter (411b) umfasst und der dritte Farbumwandlungsbereich (410c) einen dritten Emitter (411c) umfasst, und
der erste Emitter (411a) und der zweite Emitter (411b) jeweils unabhängig voneinander ein phosphoreszierendes Dotierungsmittel, ein fluoreszierendes Dotierungsmittel, ein Material mit verzögerter Fluoreszenz, einen Quantenpunkt oder eine Kombination davon umfassen, **dadurch gekennzeichnet, dass**
der dritte Emitter (411c) ein phosphoreszierendes Dotierungsmittel, ein fluoreszierendes Dotierungsmittel, ein Material mit verzögerter Fluoreszenz oder eine Kombination davon umfasst.

2. Anzeigeeinrichtung nach Anspruch 1, wobei die maximale Emissionswellenlänge des dritten Farblichts um mindestens 5 Nanometer größer ist als die maximale Emissionswellenlänge des ersten Lichts.

3. Anzeigeeinrichtung nach Anspruch 1 oder Anspruch 2, wobei der erste Emitter (411a), der zweite Emitter (411b) und der dritte Emitter (411c) voneinander verschieden sind.

4. Anzeigeeinrichtung nach einem der Ansprüche 1 bis 3, wobei der erste Emitter (411a) in einem ersten Strahlengang des ersten Lichts angeordnet ist, das von einem Abschnitt emittiert wird, der dem ersten Bereich (P1) der Leuchtdiodenvorrichtungsschicht entspricht,
der zweite Emitter (411b) in einem zweiten Strahlengang des ersten Lichts angeordnet ist, das von einem Abschnitt emittiert wird, der dem zweiten Bereich (P2) der Leuchtdiodenvorrichtungsschicht entspricht, und
der dritte Emitter (411c) in einem dritten Strahlengang des ersten Lichts angeordnet ist, das von einem Abschnitt emittiert wird, der dem dritten Bereich (P3) der Leuchtdiodenvorrichtungsschicht entspricht.

5. Anzeigeeinrichtung nach einem der Ansprüche 1 bis 4, wobei
(i) der dritte Farbumwandlungsbereich (410c) den dritten Emitter (411c) in einer Menge von 1 Gewichtsprozent bis 50 Gewichtsprozent, basierend auf dem Gesamtgewicht des dritten Farbumwandlungsbereichs (410c) umfasst; und/oder
(ii) die maximale Emissionswellenlänge des dritten Emitters (411c) zwischen 425 Nanometern und 465 Nanometern beträgt, wobei die maximale Emissionswellenlänge mit Hilfe eines Quantenausbeutespektrometers zur Bestimmung der Emissionswellenlänge eines einzelnen Films des dritten Emitters (411c) gemessen wird.

6. Anzeigeeinrichtung nach einem der Ansprüche 1 bis 5, wobei das phosphoreszierende Dotierungsmittel eine metallorganische Verbindung der Formel 401 umfasst:
Formel 401 M(L₄₀₁)_{xc1}(L₄₀₂)_{xc2}
wobei L₄₀₁ ein durch die Formel 402 dargestellter Ligand ist: 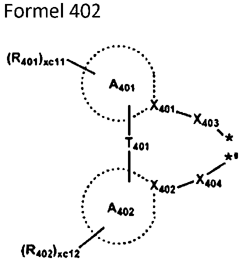 wobei in den Formeln 401 und 402
M ein Übergangsmetall ist,
xc1 gleich 1, 2 oder 3 ist, wobei, wenn xc1 gleich 2 oder 3 ist, zwei oder mehr der L₄₀₁ identisch oder voneinander verschieden sind,
L₄₀₂ ein organischer Ligand ist, und xc2 gleich 0, 1, 2, 3 oder 4 ist, wobei, wenn xc2 gleich 2, 3 oder 4 ist, zwei oder mehr L₄₀₂ identisch oder voneinander verschieden sind,
X₄₀₁ und X₄₀₂ jeweils unabhängig voneinander Stickstoff oder Kohlenstoff sind,
Ring A₄₀₁ und Ring A₄₀₂ jeweils unabhängig voneinander eine carbocyclische C₃-C₆₀-Gruppe oder eine heterocyclische C₁-C₆₀-Gruppe sind,
T₄₀₁ eine Einfachbindung, *-O-*', *-S-*', *-C(=O)-*', *-N(Q₄₁₁)-*', *-C(Q₄₁₁)(Q₄₁₂)-*', *- C(Q₄₁₁)=C(Q₄₁₂)-*', *-C=*' oder *=C=*' ist,
X₄₀₃ und X₄₀₄ jeweils unabhängig voneinander eine chemische Bindung, O, S, N(Q₄₁₃), B(Q₄₁₃), P(Q₄₁₃), C(Q₄₁₃)(O₄₁₄) oder Si(Q₄₁₃)(Q₄₁₄) sind,
R₄₀₁ und R₄₀₂ jeweils unabhängig voneinander Wasserstoff, Deuterium, -F, - Cl, -Br, -I, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₁-C₂₀-Alkylgruppe, unsubstituiert oder mit mindestens einem R₁₀ₐ substituiert, eine C₁₋C₂₀-Alkoxygruppe, unsubstituiert oder mit mindestens einem R₁₀ₐ substituiert, eine C₁-C₂₀-Alkylthiogruppe, unsubstituiert oder mit mindestens einem R₁₀ₐ substituiert, eine carbocyclische C₃-C₆₀-Gruppe unsubstituiert oder mit mindestens einem R₁₀ₐ substituiert, eine heterocyclische C₁-C₆₀-Gruppe, unsubstituiert oder mit mindestens einem R₁₀ₐ substituiert, -Si(Q₄₀₁)(Q₄₀₂)(Q₄₀₃), -N(Q₄₀₁)(Q₄₀₂), "B (Q₄₀₁) (Q₄₀₂), -C(=O)(Q₄₀₁), -S(=O)2(O₄₀₁), - P(O₄₀₁)(O₄₀₂) oder - P(=O)(Q₄₀₁)(Q₄₀₂) sind,
R₁₀ₐ ist:
Deuterium, -F, -Cl, -Br, -I, eine Hydroxylgruppe, eine Cyanogruppe oder eine Nitrogruppe;
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils unsubstituiert oder substituiert mit mindestens einem von Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer carbocyclischen C₃-C₆₀-Gruppe, einer heterocyclischen C₁-C₆₀-Gruppe, einer C₆-C₆₀-Aryloxygruppe, einer C₁-C₆₀-Heteroaryloxygruppe, einer C₆-C₆₀-Arylthiogruppe, einer C₁-C₆₀-Heteroarylthiogruppe, einer C₇-C₆₀-Arylalkylgruppe, einer C₂-C₆₀-Heteroarylalkylgruppe, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(Q₁₁)(Q₁₂), -P(=O)(Q₁₁)(Q₁₂) oder einer Kombination davon;
eine carbocyclische C₃-C₆₀-Gruppe, eine heterocyclische C₁-C₆₀-Gruppe, eine C₆-C₆₀-Aryloxygruppe, eine C₁-C₆₀-Heteroaryloxygruppe, eine C₆-C₆₀-Arylthiogruppe, eine C₁-C₆₀-Heteroarylthiogruppe, eine C₇-C₆₀-Arylalkylgruppe oder eine C₂-C₆₀-Heteroarylalkylgruppe, jeweils unsubstituiert oder substituiert mit mindestens einem von Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₁-C₆₀-Alkylthiogruppe, einer carbocyclischen C₃-C₆₀-Gruppe, einer heterocyclischen C₁-C₆₀-Gruppe, einer C₆-C₆₀-Aryloxygruppe, einer C₁-C₆₀-Heteroaryloxygruppe, einer C₆-C₆₀-Arylthiogruppe, einer C₁-C₆₀-Heteroarylthiogruppe, einer C₇-C₆₀-Arylalkylgruppe, einer C₂-C₆₀-Heteroarylalkylgruppe, -Si(Q₂₁)(Q₂₂)(Q₂₃), - N(Q₂₁)(Q₂₂), -B(Q₂₁)(Q₂₂), -C(=O)(Q₂₁), - S(=O)₂(O₂₁), -P(Q₂₁)(Q₂₂), -P(=O)(Q₂₁)(O₂₂) oder einer Kombination davon; oder
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), - P(Q₃₁)(Q₃₂) oder -P(=O)(Q₃₁)(Q₃₂),
Q₁₁ bis Q₁₃, Q₂₁ bis Q₂₃, Q₃₁ bis Q₃₃ und Q₄₁₁ bis Q₄₁₄ jeweils unabhängig voneinander sind: Wasserstoff, Deuterium; -F; -Cl; -Br; -I; eine Hydroxylgruppe; eine Cyanogruppe; eine Nitrogruppe; eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₁-C₆₀-Alkylgruppe; eine C₂-C₆₀-Alkenylgruppe; eine C₂-C₆₀-Alkinylgruppe; eine C₁-C₆₀-Alkoxygruppe; eine C₁-C₆₀-Alkylthiogruppe; eine carbocyclische C₃-C₆₀-Gruppe oder eine heterocyclische C₁-C₆₀-Gruppe, jeweils unsubstituiert oder substituiert mit mindestens einem von Deuterium, -F, einer Cyanogruppe, einer C₁-C₆₀-Alkylgruppe, einer C₁-C₆₀-Alkoxygruppe, einer C₁-C₆₀-Alkylthiogruppe, einer Phenylgruppe, einer Biphenylgruppe oder einer Kombination davon,
xc11 und xc12 jeweils unabhängig eine ganze Zahl von 0 bis 10 sind, und
* und *' in Formel 402 jeweils eine Bindungsstelle an M in Formel 401 kennzeichnen.

7. Anzeigeeinrichtung nach einem der Ansprüche 1 bis 6, wobei das fluoreszierende Dotierungsmittel eine Verbindung der Formel 501 umfasst: 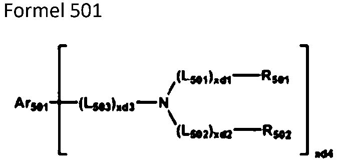 wobei in Formel 501
Ar₅₀₁, L₅₀₁ bis L₅₀₃, R₅₀₁ und R₅₀₂ jeweils unabhängig voneinander eine carbocyclische C₃-C₆₀-Gruppe, unsubstituiert oder mit mindestens einem R₁₀ₐ substituiert, oder eine heterocyclische C₁-C₆₀-Gruppe, unsubstituiert oder mit mindestens einem R₁₀ₐ substituiert, sind,
xd1 bis xd3 jeweils unabhängig voneinander 0, 1, 2 oder 3 sind,
xd4 gleich 1, 2, 3, 4, 5 oder 6 ist, und
R₁₀ₐ wie in Anspruch 6 beschrieben ist.

8. Anzeigeeinrichtung nach einem der Ansprüche 1 bis 7, wobei
(i) das Material mit verzögerter Fluoreszenz i) ein Material, das mindestens einen Elektronendonator und mindestens einen Elektronenakzeptor umfasst, ii) ein Material, das eine polycyclische C₈-C₆₀-Gruppe umfasst, wobei zwei oder mehr cyclische Gruppen unter gemeinsamer Nutzung eines Boratoms (B) kondensiert sind, oder eine Kombination davon umfasst; und/oder
(ii) der Quantenpunkt eine Halbleiterverbindung der Gruppe II-VI, eine Halbleiterverbindung der Gruppe III-V, eine Halbleiterverbindung der Gruppe III-VI, eine Halbleiterverbindung der Gruppe I-III-VI, eine Halbleiterverbindung der Gruppe IV-VI, ein Element oder eine Verbindung der Gruppe IV oder eine Kombination davon umfasst.

9. Anzeigeeinrichtung nach einem der Ansprüche 1 bis 8, wobei mindestens einer des ersten Farbumwandlungsbereichs (410a), des zweiten Farbumwandlungsbereichs (410b) und des dritten Farbumwandlungsbereichs (410c) zusätzlich einen Streuer (412a, 412b, 412c) umfasst, wobei der Streuer (412a, 412b, 412c) optional BiFeO₃, Fe₂O₃, WO₃, TiO₂, SiC, BaTiO₃, ZnO, ZrO₂, ZrO, Ta₂O₅, MoO₃, TeO₂, Nb₂O₅, Fe₃O₄, V₂O₅, Cu₂O, BP, Al₂O₃, In₂O₃, SnO₂, Sb₂O₃, ITO oder eine Kombination davon umfasst.

10. Anzeigeeinrichtung nach einem der Ansprüche 1 bis 9, wobei jede Leuchtdiodenvorrichtung der mindestens einen Leuchtdiodenvorrichtung (10) Folgendes umfasst:
eine erste Elektrode (110);
eine zweite Elektrode (150), die der ersten Elektrode (110) zugewandt ist; und
eine Zwischenschicht (130), die zwischen der ersten Elektrode (110) und der zweiten Elektrode (150) angeordnet ist, wobei die Zwischenschicht (130) mindestens eine Emissionsschicht umfasst.

11. Anzeigeeinrichtung nach Anspruch 10, wobei jede Emissionsschicht der mindestens einen Emissionsschicht unabhängig voneinander ein phosphoreszierendes Dotierungsmittel, ein fluoreszierendes Dotierungsmittel, ein Material mit verzögerter Fluoreszenz, einen Quantenpunkt oder eine Kombination davon umfasst.

12. Anzeigeeinrichtung nach Anspruch 10 oder 11, wobei es sich bei der mindestens einen Leuchtdiodenvorrichtung (10) um eine Tandem-Leuchtdiodenvorrichtung handelt, umfassend: mindestens zwei Emissionszonen, die nacheinander zwischen der ersten Elektrode (110) und der zweiten Elektrode (150) gestapelt sind; und eine Ladungserzeugungsschicht (133), die zwischen den mindestens zwei Emissionszonen angeordnet ist, wobei die mindestens zwei in der Tandem-Leuchtdiodenvorrichtung enthaltenen Emissionszonen optional Licht mit maximalen Emissionswellenlängen ausstrahlen, die gleich oder verschieden sind.

13. Anzeigeeinrichtung nach einem der Ansprüche 1 bis 12, wobei die maximale Emissionswellenlänge des ersten Lichts 420 Nanometer bis 460 Nanometer beträgt, wobei die maximale Emissionswellenlänge mit Hilfe eines Quantenausbeutespektrometers zur Bestimmung der Emissionswellenlänge eines einzelnen Films einer Emissionsschicht der Leuchtdiodenvorrichtung gemessen wird.

14. Anzeigeeinrichtung nach einem der Ansprüche 1 bis 13, weiter umfassend mindestens einen Farbfilter (420a, 420b, 420c), der auf der Farbumwandlungsschicht so angeordnet ist, dass er mindestens einem von dem ersten Farbumwandlungsbereich (410a), dem zweiten Farbumwandlungsbereich (410b), dem dritten Farbumwandlungsbereich (410c) oder einer Kombination davon entspricht.

## Revendications

1. Appareil d'affichage, comprenant :
un substrat (100) ;
une couche de dispositif électroluminescent agencée sur le substrat (100), dans lequel la couche de dispositif électroluminescent comprend une première zone (P1), une deuxième zone (P2) et une troisième zone (P3), et dans lequel la couche du dispositif électroluminescent comprend en outre au moins un dispositif électroluminescent (10) émettant une première lumière ; et
une couche de conversion de couleur agencée sur la couche du dispositif électroluminescent, dans lequel la couche de conversion de couleur comprend une première zone de conversion de couleur (410a), une deuxième zone de conversion de couleur (410b) et une troisième zone de conversion de couleur (410c),
dans lequel la première zone de conversion de couleur (410a) est agencée pour correspondre à la première zone (P1) de la couche du dispositif électroluminescent, et émet une première lumière de couleur,
la deuxième zone de conversion de couleur (410b) est agencée pour correspondre à la deuxième zone (P2) de la couche du dispositif électroluminescent et émet une deuxième lumière de couleur,
la troisième zone de conversion de couleur (410c) est agencée pour correspondre à la troisième zone (P3) de la couche du dispositif électroluminescent et émet une lumière de troisième couleur,
dans lequel une longueur d'onde d'émission maximale de la lumière de première couleur, une longueur d'onde d'émission maximale de la lumière de deuxième couleur et une longueur d'onde d'émission maximale de la lumière de troisième couleur sont identiques ou différentes l'une de l'autre, et
La couleur de la troisième lumière est identique à celle de la première lumière, et
la longueur d'onde d'émission maximale de la troisième lumière colorée est supérieure à la longueur d'onde d'émission maximale de la première lumière.
dans lequel la première zone de conversion de couleur (410a) comprend un premier émetteur (411a), la deuxième zone de conversion de couleur (410b) comprend un deuxième émetteur (411b), et la troisième zone de conversion de couleur (410c) comprend un troisième émetteur (411c), et
le premier émetteur (411a) et le second émetteur (411b) comprennent chacun indépendamment un dopant phosphorescent, un dopant fluorescent, un matériau à fluorescence retardée, un point quantique, ou une combinaison de ceux-ci, **caractérisés en ce que**
le troisième émetteur (411 c) comprend un dopant phosphorescent, un dopant fluorescent, un matériau à fluorescence retardée, ou une combinaison de ceux-ci.

2. Appareil d'affichage selon la revendication 1, dans lequel la longueur d'onde d'émission maximale de la troisième lumière de couleur est supérieure d'au moins 5 nanomètres à la longueur d'onde d'émission maximale de la première lumière.

3. Appareil d'affichage selon la revendication 1 ou la revendication 2, dans lequel le premier émetteur (411a), le deuxième émetteur (411b) et le troisième émetteur (411c) sont différents les uns des autres.

4. Appareil d'affichage selon l'une quelconque des revendications 1 à 3, dans lequel le premier émetteur (411a) est agencé dans un premier trajet de la première lumière émise par une partie correspondant à la première zone (P1) de la couche du dispositif électroluminescent,
le deuxième émetteur (411b) est agencé sur un deuxième trajet de la première lumière émise par une portion correspondant à la deuxième zone (P2) de la couche du dispositif électroluminescent, et
le troisième émetteur (411c) est agencé dans un troisième trajet de la première lumière émise à partir d'une portion correspondant à la troisième zone (P3) de la couche du dispositif électroluminescent.

5. Appareil d'affichage selon l'une quelconque des revendications 1 à 4, dans lequel
(i) la troisième zone de conversion de couleur (410c) comprend le troisième émetteur (411c) dans une quantité de 1 pour cent en poids à 50 pour cent en poids sur la base d'un poids total de la troisième zone de conversion de couleur (410c) ; et/ou
(ii) la longueur d'onde d'émission maximale du troisième émetteur (411c) est de 425 nanomètres à 465 nanomètres, dans lequel la longueur d'onde d'émission maximale est mesurée à l'aide d'un spectromètre à rendement quantique pour déterminer la longueur d'onde d'émission d'un seul film du troisième émetteur (411c).

6. Appareil d'affichage selon l'une quelconque des revendications 1 à 5, dans lequel le dopant phosphorescent comprend un composé organométallique représenté par la formule 401 :
Formule 401 M(L₄₀₁)_{xc1}(L₄₀₂)_{xc2}
dans laquelle L₄₀₁ est un ligand représenté par la formule 402 : 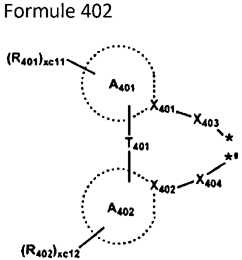 dans lequel, dans les Formules 401 et 402,
M est un métal de transition,
xc1 est 1, 2 ou 3, où, lorsque xc1 est 2 ou 3, deux ou plusieurs L₄₀₁ sont identiques ou différents l'un de l'autre,
L₄₀₂ est un ligand organique, et xc2 vaut 0, 1,2, 3 ou 4, dans lequel, lorsque xc2 vaut 2, 3 ou 4, deux ou plusieurs L₄₀₂ sont identiques ou différents l'un de l'autre,
X₄₀₁ et X₄₀₂ sont chacun indépendamment de l'azote ou du carbone, l'anneau A₄₀₁ et l'anneau A₄₀₂ sont chacun indépendamment un groupe carbocyclique en C₁-C₆₀ ou un groupe hétérocyclique en C₁-C₆₀ ,
T₄₀₁ est une liaison simple, *-O-*', *-S-*', *-C(=O)-*', *-N(Q₄₁₁)-*', *-C(Q₄₁₁)(Q₄₁₂))-*', *- C(Q₄₁₁)=C(Q₄₁₂)-*' , *-C=*', ou *=C=*',
X₄₀₃ et X₄₀₄ sont chacun indépendamment une liaison chimique, O, S, N(Q₄₁₃), B(Q₄₁₃), P(Q₄₁₃), C(Q₄₁₃)(Q₄₁₄), ou Si(Q₄₁₃)(Q₄₁₄),
R₄₀₁ et R₄₀₂ représentent chacun indépendamment un atome d'hydrogène,un deutérium, un groupe -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle enC₁-C₂₀ non substitué ou substitué par au moins ungroupe R₁₀ₐ, un groupe alcoxyen C₁-C₂₀ non substitué ou substitué par au moins un groupeR₁₀ₐ, un groupe alkylthioen C₁-C₂₀ non substitué ou substitué par au moins un groupeR₁₀ₐ, un groupe carbocyclique enC₃-C₆₀ non substitué ou substitué par au moins un groupeR₁₀ₐ, un groupe hétérocycliqueen C₁-C₆₀ non substitué ou substitué avec au moins un R₁₀ₐ, -Si(Q₄₀₁)(Q₄₀₂)(Q₄₀₃), -N(Q₄₀₁)(Q₄₀₂), "B(Q₄₀₁)(Q402), -C(=O)(Q₄₀₁), -S(=O)₂(Q₄₀₁), - P(Q₄₀₁)(Q₄₀₂), ou -P(=O)(Q₄₀₁)(Q₄₀₂),
R₁₀ₐ est :
un deutérium, -F, -Cl, -Br, -I, un groupe hydroxyle, un groupe cyano ou un groupe nitro ;
un groupe alkyleenC₁-C₆₀, un groupe alcényleen C₂-C₆₀, un groupe alcynyleen C₂-C₆₀, un groupe alcoxyen C₁-C₆₀ ou un groupe alkylthio enC₁-C₆₀, chacun non substitué ou substitué par au moins un des éléments suivants : deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe carbocycliqueen C₃-C₆₀, un groupe hétérocycliqueen C₁-C₆₀, un groupe aryloxy enC₆-C₆₀, un groupe hétéroaryloxy enC₁-C₆₀, un groupe arylthio enC₆-C₆₀ groupe, un groupe hétéroarylthio C₁-C₆₀, un groupe aryl alkyl C₇-C₆₀, un groupe hétéroaryl alkyl C₂-C₆₀, -Si(Q₁₁)(Q₁₂)(Q₁₃), -N(Q₁₁)(Q₁₂), -B(Q₁₁)(Q₁₂), - C(=O)(Q₁₁), -S(=O)₂(O₁₁), -P(Q₁₁)(Q₁₂), -P(=O)(Q₁₁)(Q₁₂), ou une combinaison de celles-ci;
un groupe carbocycliqueen C₃-C₆₀, un groupe hétérocycliqueen C₁-C₆₀, un groupe aryloxyen C₆-C₆₀, un groupe hétéroaryloxyen C₁-C₆₀, un groupe arylthioen C₆-C₆₀, un groupe hétéroarylthio enC₁-C₆₀, un groupe arylalkyleen C₇-C₆₀ ou un groupe hétéroarylalkyle enC₂-C₆₀, chacun non substitué ou substitué par au moins un des groupes suivants : deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle enC₁-C₆₀, un groupeC₂-C₆₀ groupe alcényle, groupe alcynyleen C₂-C₆₀, groupe alcoxy enC₁-C₆₀, groupe alkylthioen C₁-C₆₀, groupe carbocycliqueen C₃-C₆₀, groupe hétérocyclique enC₁-C₆₀, groupe aryloxyen C₆-C₆₀, groupe hétéroaryloxyen C₁-C₆₀, groupe arylthio enC₆-C₆₀, groupe hétéroarylthio enC₁-C₆₀, groupe arylalkyle enC₇-C₆₀, groupe hétéroarylalkyle en C₂-C₆₀, - Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(Q₂₁)(Q₂₂), - P(=O)(Q₂₁)(Q₂₂), ou une combinaison de celles-ci; ou
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), - P(Q₃₁)(Q₃₂), ou -P(=O)(Q₃₁)(Q₃₂),
Q₁₁ à Q₁₃, Q₂₁ à Q₂₃, Q₃₁ à Q₃₃et Q₄₁₁ à Q₄₁₄ représentent chacune indépendamment : hydrogène, deutérium ; -F ; -CI ; -Br ; -I ; un groupe hydroxyle ; un groupe cyano ; un groupe nitro ; un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ ; un groupe alcényle en C₂-C₆₀ ; un groupe alcynyle en C₂-C₆₀ ; un groupe alcoxy en C₁-C₆₀ ; un groupe alkylthio en C₁-C₆₀ ; un groupe carbocycliqueen C₃-C₆₀ ou un groupe hétérocycliqueen C₁-C₆₀, chacun non substitué ou substitué par au moins un des groupes suivants : deutérium, -F, un groupe cyano, un groupe alkyleen C₁-C₆₀, un groupe alcoxy enC₁-C₆₀, un groupe alkylthioen C₁-C₆₀, un groupe phényle, un groupe biphényle ou une combinaison de ceux-ci ;
xc11 et xc12 sont chacun indépendamment un nombre entier allant de 0 à 10,
* et * ' dans la formule 402, indique chacun un site de liaison à M dans la formule 401.

7. Appareil d'affichage selon l'une quelconque des revendications 1 à 6, dans lequel le dopant fluorescent comprend un composé représenté par la formule 501 : 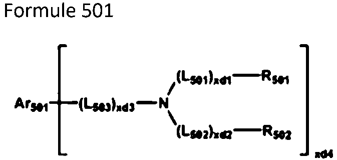 dans lequel dans la formule 501,
Ar₅₀₁, L₅₀₁ à L₅₀₃, R₅₀₁, et R₅₀₂ sont chacun indépendamment un groupe carbocyclique en C₃-C₆₀ non substitué ou substitué par au moins un R₁₀ₐ ou un groupe hétérocyclique en C₁-C₆₀ non substitué ou substitué par au moins un R₁₀ₐ,
xd1 à xd3 sont chacun indépendamment 0, 1, 2 ou 3,
xd4 vaut 1, 2, 3, 4, 5 ou 6, et
R₁₀ₐ est tel que décrit dans la revendication 6.

8. Appareil d'affichage selon l'une quelconque des revendications 1 à 7, dans lequel
(i) le matériau à fluorescence retardée comprend i) un matériau comprenant au moins un donneur d'électrons et au moins un accepteur d'électrons, ii) un matériau comprenant un groupe polycyclique C₈-C₆₀ dans lequel deux ou plusieurs groupes cycliques sont condensés tout en partageant un atome de bore (B), ou une combinaison de ceux-ci ; et/ou
(ii) le point quantique comprend un composé semi-conducteur du groupe II-VI, un composé semi-conducteur du groupe III-V, un composé semi-conducteur du groupe III-VI, un composé semi-conducteur du groupe I-III-VI, un composé semi-conducteur du groupe IV-VI, un élément ou composé du groupe IV, ou une combinaison de ceux-ci.

9. Appareil d'affichage selonl' une quelconque des revendications 1 à 8, dans lequel au moins une des zones de conversion de couleur (410a, 410b ou 410c) comprend en outre un diffuseur (412a, 412b ou 412c), ce diffuseur (412a, 412b ou 412c) étant optionnellement composé de BiFeO₃, Fe₂O, WO₃, TiO₂, SiC, BaTiO₃, ZnO, ZrO₂, ZrO,Ta₂O₅, MoO₃, TeO₂, Nb₂O₃, Fe₃O₄, V₂O₅, Cu₂O, BP,Al₂O₃, In₂O₃, SnO₂ouSb₂O₃, ITO, ou une combinaison de ceux-ci.

10. Appareil d'affichage selon l'une quelconque des revendications 1 à 9, dans lequel chaque dispositif électroluminescent du au moins un dispositif électroluminescent (10) comprend :
une première électrode (110) ;
une seconde électrode (150) faisant face à la première électrode (110) ; et
une couche intermédiaire (130) agencée entre la première électrode (110) et dans lequel la seconde électrode (150) comprend au moins une couche d'émission,

11. Appareil d'affichage selon la revendication 10, dans lequel chaque couche d'émission de ladite au moins une couche d'émission comprend indépendamment un dopant phosphorescent, un dopant fluorescent, un matériau à fluorescence retardée, un point quantique ou une combinaison de ceux-ci.

12. Appareil d'affichage selon la revendication 10 ou la revendication 11, dans lequel le au moins un dispositif électroluminescent (10) est un dispositif électroluminescent tandem comprenant : au moins deux zones d'émission empilées séquentiellement entre la première électrode (110) et la deuxième électrode (150) ; et une couche de génération de charge (133) agencée entre les au moins deux zones d'émission, dans lequel, optionnellement, les au moins deux zones d'émission incluses dans le dispositif électroluminescent tandem émettent une lumière présentant des longueurs d'onde d'émission maximales identiques ou différentes l'une de l'autre.

13. Appareil d'affichage selon l'une quelconque des revendications 1 à 12, dans lequel la longueur d'onde d'émission maximale de la première lumière est de 420 nanomètres à 460 nanomètres, dans lequel la longueur d'onde d'émission maximale est mesurée à l'aide d'un spectromètre à rendement quantique pour déterminer la longueur d'onde d'émission d'un seul film d'une couche d'émission du dispositif électroluminescent.

14. Appareil d'affichage selon l'une quelconque des revendications 1 à 13, comprenant en outre au moins un filtre de couleur (420a, 420b, 420c) agencé sur la couche de conversion de couleur pour correspondre à au moins une des zones de conversion de couleur (410a), la deuxième zone de conversion de couleur (410b), la troisième zone de conversion de couleur (410c) ou une combinaison de celles-ci.
